(19) Europäisches Patentamt
European Patent Office
Office européen des brevets

(11) **EP 1 950 175 B1**

(12) **FASCICULE DE BREVET EUROPEEN**

(45) Date de publication et mention
de la délivrance du brevet:
**25.03.2015 Bulletin 2015/13**

(51) Int Cl.:
***B81C 1/00*** *(2006.01)*

(21) Numéro de dépôt: **08100608.2**

(22) Date de dépôt: **17.01.2008**

(54) **Procédé de réalisation d'un capot de protection de composant sur un substrat**

Verfahren zur Herstellung einer Verkapselung für ein Bauteil auf einem Substrat

Process for manufacturing a package for a component on a substrate

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **26.01.2007 FR 0752907**

(43) Date de publication de la demande:
**30.07.2008 Bulletin 2008/31**

(73) Titulaire: **Commissariat à l'Énergie Atomique et aux Énergies Alternatives
75015 Paris (FR)**

(72) Inventeur: **Bolis, Sébastien
38920, CROLLES (FR)**

(74) Mandataire: **Ilgart, Jean-Christophe
BREVALEX
95, rue d'Amsterdam
75378 Paris Cedex 8 (FR)**

(56) Documents cités:
**FR-A- 2 864 341**

**Description**

**DOMAINE TECHNIQUE**

La présente invention concerne un procédé de réalisation d'un capot sur un substrat notamment pour l'encapsulation de composants électroniques, optiques, optoélectroniques, de type microsystèmes électromécaniques, aussi connus sous le sigle MEMS (soit Micro-Electro-Mechanical Systems en anglais) ou optoélectromécaniques aussi connus sous le sigle MOEMS (soit Micro-Opto-Electro-Mechanical Systems en anglais) solidaires du substrat. Dans la suite de la description on a utilisé composant ou quelquefois microsystème.

**ÉTAT DE LA TECHNIQUE ANTÉRIEURE**

Dans le domaine de l'encapsulation, les composants, de type microsystèmes notamment, comprennent des éléments fonctionnels fragiles qu'il faut protéger en vue d'opérations d'assemblage traditionnelles ultérieures. Ces microsystèmes sont le plus souvent réalisés de manière collective sur une tranche (wafer en anglais) de matériau semi-conducteur. Lors de l'encapsulation, on peut également venir rapporter sur chacun des composants un capot unitaire lui-même issu d'une tranche, mais de plus en plus, on essaye de procéder de manière collective par dépôt de couches minces en prévoyant du matériau sacrificiel sur le composant pour délimiter la forme intérieure de la cavité que devra délimiter le capot, ce matériau sacrificiel étant ôté en final. Un tel procédé est décrit par exemple dans FR 2 864 341 - A1. Une telle fabrication collective est relativement longue et compliquée, il faut déposer le matériau sacrificiel, le modeler, déposer le matériau du capot, éliminer le matériau sacrificiel par un orifice du capot et enfin boucher l'orifice du capot. De plus, les capots obtenus risquent de ne pas être assez robustes en flexion et de ne pas résister à l'étape d'injection plastique avec laquelle on surmoule le composant.

En ce qui concerne le report de capot de manière collective en utilisant le collage de plaquette, cette technique nécessite un équipement de collage de plaquette qui n'est pas un moyen standard de l'industrie microélectronique.

**EXPOSÉ DE L'INVENTION**

La présente invention a justement comme but de proposer un procédé de réalisation d'un capot de protection d'un composant sur un substrat qui ne présente pas les inconvénients mentionnés ci-dessus.

Un but de l'invention est la réalisation d'un capot de protection qui soit simple et qui permette d'éviter l'utilisation de matériau sacrificiel pour définir le volume intérieur de la cavité délimitée par le capot.

Un autre but du procédé de l'invention est de réaliser un capot plus robuste que les capots couche mince.

Un autre but de l'invention est réaliser un capot étanche délimitant une cavité dont la pression peut être contrôlée.

Pour y parvenir, la présente invention propose un procédé de réalisation d'un capot de protection d'un composant logé sur ou au sein d'un substrat comprenant les étapes suivantes :

définition sur le substrat d'au moins une zone d'ancrage du capot au substrat, décalée d'une zone centrale dans laquelle se trouve le composant,

formation d'une couche de flambage monocouche ou a plusieurs sous-couches empilées, sur le substrat, s'étendant sur la zone centrale et au delà, la couche de flambage présentant une adhérence au substrat dans la zone centrale inférieure à celle présentée dans la zone d'ancrage,

flambage de la couche de flambage de manière à ce qu'elle délimite une cavité au niveau de la zone centrale et soit ancrée au substrat au niveau de la zone d'ancrage,

l'étape de définition pouvant être réalisée avant, pendant ou après l'étape de formation mais avant l'étape de flambage, l'étape de flambage pouvant être réalisée pendant ou après l'étape de formation.

La formation de la couche de flambage peut se faire par dépôt de couche mince de type dépôt chimique en phase vapeur, dépôt physique en phase gazeuse (par exemple pulvérisation, évaporation), électrolyse, épitaxie, oxydation thermique, par dépôt sous vide, par laminage de film, par dépôt à la tournette, par pulvérisation, par moulage, par collage moléculaire, par soudage eutectique, par collage organique, par collage anodique.

La formation de la couche de flambage peut inclure une étape de structuration de la couche de flambage.

La couche de flambage ou les sous-couches de la couche de flambage peuvent être réalisées en matériau organique choisi parmi des résines photosensibles comme le benzocyclobutène ou le polyéthylène téréphtalate, le parylène, le polydiméthylsiloxane, en matériau métallique choisi parmi le titane, le cuivre, l'aluminium ou leurs alliages, en matériau minéral choisi parmi le silicium, le silicium germanium, l'oxyde de silicium, le nitrure de silicium, le carbure de silicium, le carbone diamant, le nitrure de titane.

Le flambage peut être réalisé par maintien sous contrainte par un traitement thermique de la couche de flambage ou d'au moins une sous-couche de la couche de flambage.

La contrainte peut être induite par le substrat qui possède alors un coefficient de dilatation thermique supérieur à celui de la couche de flambage ou de la sous-couche de flambage.

En variante ou en combinaison, la contrainte peut être induite par au moins une sous-couche de la couche de flambage qui possède un coefficient de dilatation thermique supérieur à celui d'une autre sous-couche de la couche de flambage.

Le procédé peut comporter une étape de formation d'au moins un élément de compression en périphérie de la couche de flambage, au niveau de la zone d'ancrage, cet élément de compression ayant un coefficient de dilatation thermique supérieur à celui de la couche de flambage ou d'au moins une des sous-couches de la couche de flambage et une rigidité supérieure à celle de la couche de flambage, la contrainte étant induite par l'élément de compression.

En variante ou en combinaison, le flambage peut être obtenu par une implantation ionique localisée de la couche de flambage au niveau de la zone centrale éventuellement couplée à une activation thermique simultanée et/ou ultérieure.

Le procédé peut comprendre une étape de dépôt d'un revêtement à coefficient de dilatation thermique inférieur à celui de la couche de flambage en périphérie de la couche de flambage, après le flambage, cette étape de dépôt étant suivie d'une étape de traitement thermique.

En variante ou en combinaison, le flambage peut être obtenu par dépôt par épitaxie sous contrainte d'au moins une sous-couche de la couche de flambage, cette étape étant éventuellement couplée à un traitement thermique.

En variante ou en combinaison, le flambage peut être obtenu par écrouissage sous plasma d'au moins une sous-couche de la couche de flambage, cette étape étant éventuellement couplée à un traitement thermique.

On peut envisager que l'élément de compression soit soumis à une implantation ionique, un écrouissage sous plasma, un dépôt par épitaxie sous contrainte.

La définition de la zone d'ancrage peut se faire par réalisation d'un ou plusieurs points d'ancrage de la couche de flambage, en creux dans le substrat, au-delà de la zone centrale, avant la formation de la couche de flambage.

En variante ou en combinaison, la définition de la zone d'ancrage peut se faire par traitement localisé du substrat et/ou de la couche de flambage visant à augmenter l'adhérence de la couche de flambage sur le substrat au-delà de la zone centrale.

Le traitement peut être une application de plasma d'oxygène pour augmenter la rugosité de surface ou activer chimiquement la surface.

En variante ou en combinaison, la définition de la zone d'ancrage peut se faire par dépôt localisé sur le substrat et/ou la couche de flambage d'un matériau visant à augmenter l'adhérence de la couche de flambage sur le substrat au-delà de la zone centrale.

Le matériau est de la colle, de la soudure eutectique, un primaire d'adhérence.

En variante ou en combinaison, la définition de la zone d'ancrage peut se faire par dépôt localisé sur le substrat et/ou sur la couche de flambage d'un matériau visant à dégrader l'adhérence de la couche de flambage sur le substrat au niveau de la zone centrale.

Le matériau peut être un matériau peu ou pas adhérent choisi parmi le polytétrafluoroéthylène, les silicones, le parylène, le polydiméthysiloxane, certaines résines photosensibles.

Le matériau peut être un matériau apte à être évaporé ou dégradé thermiquement, la couche de flambage comportant une première sous-couche poreuse que l'on recouvre d'au moins une autre sous-couche après l'évaporation ou la dégradation du matériau.

Avantageusement ce matériau est aqueux ou une résine photosensible à base de polycarbonate par exemple l'Unity 2203 de chez Promerus.

Il est possible de prévoir une étape de traitement thermique ou de mise sous pression contrôlée après l'évaporation ou la dégradation pour permettre l'évacuation de résidus du matériau.

En variante ou en combinaison, la définition de la zone d'ancrage peut se faire par traitement localisé du substrat et/ou de la couche de flambage visant à dégrader l'adhérence de la couche de flambage sur le substrat au niveau de la zone centrale.

Le traitement peut être un traitement plasma visant à augmenter la rugosité en surface.

En variante ou en combinaison, la définition de la zone d'ancrage peut se faire, par apport d'énergie localisé, au travers du substrat et de la couche de flambage superposés même si cette dernière est inachevée au-delà de la zone centrale.

La présente invention concerne également un composant encapsulé comportant un substrat, un capot solidaire du substrat au niveau d'au moins une zone d'ancrage, délimitant une cavité dans laquelle se trouve le composant, le capot étant une couche de flambage flambée.

La couche de flambage peut être monocouche ou comporter plusieurs sous-couches empilées.

La couche de flambage peut être structurée.

La couche de flambage ou les sous-couches de la couche de flambage peuvent être en matériau organique choisi parmi des résines photosensibles comme le benzocyclobutène ou le polyéthylène téréphtalate, le parylène, le polydiméthylsiloxane, en matériau métallique choisi parmi le titane, le cuivre, l'aluminium ou leurs alliages, en matériau minéral choisi parmi le silicium, l'oxyde de silicium, le nitrure de silicium, le carbure de silicium, le carbone diamant, le nitrure de titane.

Une ou plusieurs sous couches peuvent venir en contact avec le substrat dans la zone d'ancrage.

L'une des sous-couches dont une face est exposée au moins en partie à l'intérieur de la cavité peut avoir un rôle de getter, si la cavité est soumise au vide.

L'une des sous-couches dont une face est exposée au moins en partie à l'intérieur de la cavité peut être poreuse.

L'une des sous-couches qui se trouve du côté de l'intérieur de la cavité peut avoir un rôle de découplage mécanique avec le substrat.

L'une des sous-couches peut avoir un rôle de tenue mécanique du capot.

Il est préférable que le substrat ait un coefficient de dilatation thermique supérieur à celui de la couche de flambage ou à celui de l'une au moins de ses sous-couches.

En variante, une des sous-couches de la couche de flambage peut avoir un coefficient de dilatation thermique supérieur à celui d'une autre sous-couche de la couche de flambage.

Au moins un élément de compression peut surmonter la périphérie de la couche de flambage pour assurer une contrainte dans le capot.

Le substrat peut comporter un ou plusieurs points d'ancrage en creux de la couche de flambage.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

les figures 1A à 1C montrent des étapes de réalisation d'un capot selon un premier exemple du procédé de l'invention et les figures 1D et 1E montrent la zone d'ancrage sur le substrat ;

les figures 2A à 2D montrent des étapes de réalisation d'un capot selon un second exemple du procédé de l'invention ;

les figures 3A à 3D montrent des étapes de réalisation d'un capot selon un troisième exemple du procédé de l'invention ;

les figures 4A et 4B montrent des étapes de réalisation d'un capot selon un quatrième exemple du procédé de l'invention ;

les figures 5A à 5D montrent des étapes de réalisation d'un capot selon un cinquième et un sixième exemple du procédé de l'invention ;

les figures 6A à 6F montrent des étapes de réalisation d'un capot selon un septième, un huitième et un neuvième exemple du procédé de l'invention ;

les figures 7A et 7B montrent deux nouveaux exemples de composant encapsulé selon l'invention ;

les figures 8A à 8C montrent étapes de réalisation d'un capot selon un nouvel exemple du procédé de l'invention et les figures 8D à 8F montrent encore trois nouveaux exemples de composant encapsulé selon l'invention ;

les figures 9A à 9C montrent un exemple de flambage de la couche de flambage par implantation ionique ;

les figures 10A à 10F montrent des exemples de dépôt pour définir la zone d'ancrage ;

les figures 11A à 11D montrent des exemples de traitement visant à définir la zone d'ancrage ;

les figures 12A à 12D montrent des étapes de réalisation d'un exemple de capot pour microsystème fabriqué en masse et la figure 12E est un graphique illustrant la variation de la flèche en fonction de l'épaisseur de la couche d'oxyde de la couche de flambage ;

les figures 13A à 13C montrent des étapes de réalisation d'un exemple de capot étanche pour microsystème et la figure 13D est un graphique illustrant la variation de la flèche en fonction de l'épaisseur de la couche de flambage.

Les différentes variantes décrites doivent être comprises comme n'étant pas exclusives les unes des autres.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles. Des fonds semblables qui remplissent les figures ne représentent pas toujours un même matériau.

## EXPOSÉ DÉTAILLÉ DE MODES DE RÉALISATION PARTICULIERS

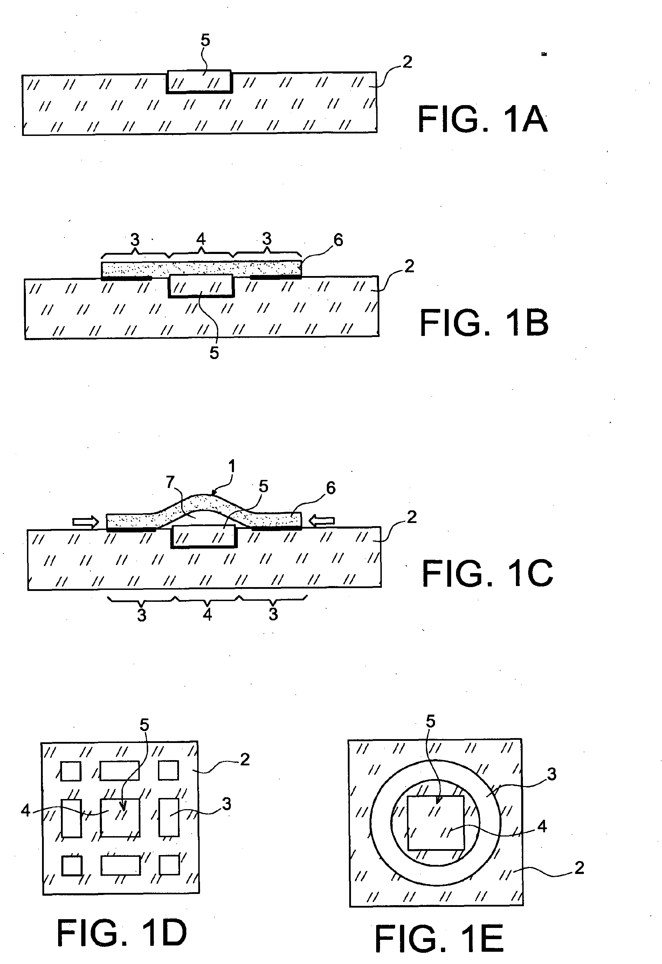

On va maintenant décrire un exemple de procédé de réalisation d'au moins un capot 1 sur un substrat 2 sur lequel ou au sein duquel est logé un composant 5. On se réfère à la figure 1A. Le composant 5 peut être de type microsystème électromécanique ou optoélectromécanique par exemple un MEMS radiofréquence, un accéléromètre, un filtre à ondes acoustiques de volume, un capteur inertiel de type accéléromètre ou gyroscope. Il pourrait bien entendu s'agir d'un composant électronique, optique ou optoélectronique. On va définir sur le substrat 2 au moins une zone d'ancrage 3 décalée d'une zone centrale 4 dans laquelle se trouve le composant 5. On se réfère à la figure 1B. Il peut y avoir plusieurs zones d'ancrage 3 disjointes formant un motif entourant la zone centrale 4 dans la mesure où le capot 1 n'a pas besoin d'être étanche comme sur la figure 1D. Le motif est carré, et il y a huit zones d'ancrage 3. Dans le cas contraire, la zone d'ancrage 3 peut être continue, comme sur la figure 1E, elle est en forme de couronne, elle entoure la zone centrale 4. Les formes données ne sont pas limitatives.

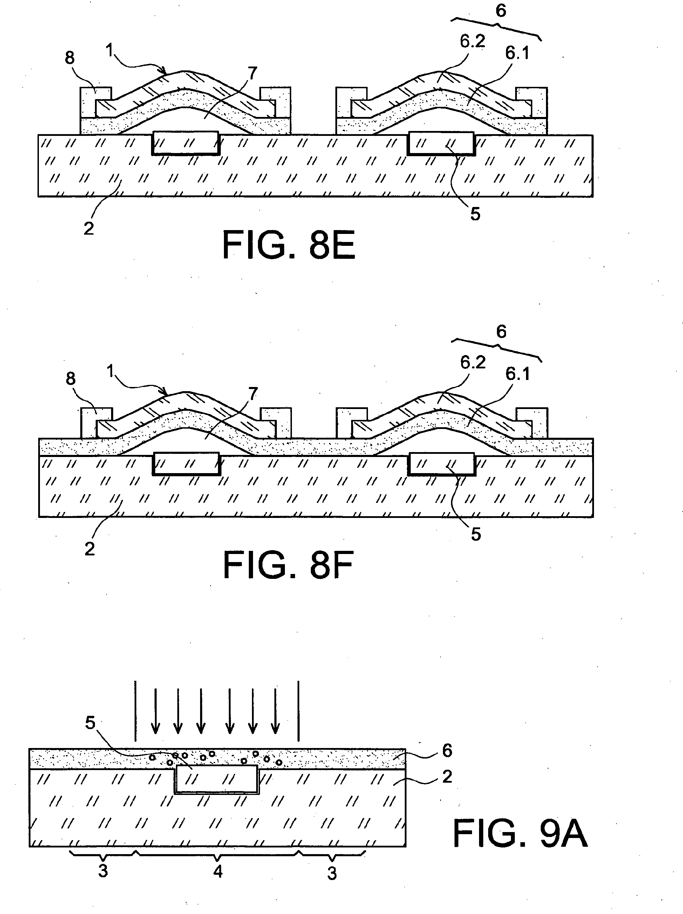

Le substrat 2 peut être un substrat en matériau semi-conducteur, par exemple en silicium, comportant au niveau de la zone centrale 4, le composant 5. Dans cette configuration le substrat 2 est traité puisqu'il possède en son sein le composant 5 qui a pu être réalisé notamment par gravure. On forme à la surface de la zone centrale 4 et de la zone d'ancrage 3 une couche de flambage 6 (figure 1B). On fait flamber la couche de flambage 6 en prenant soin qu'elle se bombe en restant accrochée au moins en partie au substrat au niveau de la zone d'ancrage 3 de manière à obtenir le capot 1 délimitant une cavité 7 de volume adéquat au dessus de la zone centrale 4 du substrat 2 (figure 1C). S'il y a plusieurs composants sur le substrat 2, on procède de la même manière avec une couche de flambage par composant comme illustré à la figure 8E ou une seule couche de flambage pour tout le substrat 2 ou même une seule des sous-couches de la couche de flambage lorsque la couche de flambage est multicouche comme illustré à la figure 8F.

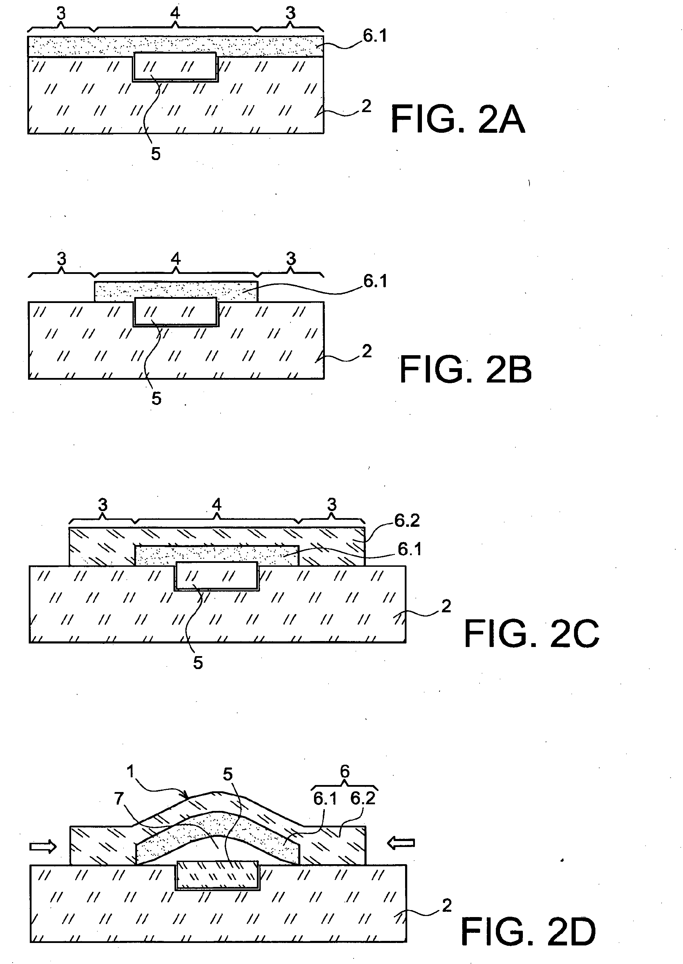

La couche de flambage 6 peut être monocouche comme illustré sur les figures 1 ou multicouche comme illustré sur les figures 2 décrites ultérieurement, où l'on voit plusieurs sous-couches.

La couche de flambage 6 ou ses sous-couches peuvent être réalisées en matériau minéral tel que, par exemple, le silicium, le silicium germanium, l'oxyde de silicium qu'il soit polycristallin, monocristallin ou amorphe, le nitrure de silicium, le carbure de silicium, le carbone diamant, le nitrure de titane, en matériau métallique tel que, par exemple, le titane, le cuivre, l'aluminium ou leurs alliages, en matériau organique tel que, par exemple, une résine photosensible comme le benzocyclobutène BCB, ou le polyéthylène téréphtalate PET, le poly-para-xylylène ou parylène, le polydiméthylsiloxane PDMS.

La formation de la couche de flambage 6 peut se faire par tous moyens connus parmi lesquels on peut citer : les dépôts de couche mince, le laminage de film, le dépôt à la tournette ou la pulvérisation pour les dépôts organiques ou de type sol gel, le moulage, la soudure eutectique. Les dépôts en couche mince peuvent se faire par dépôt chimique en phase vapeur connu sous le sigle CVD (pour chemical vapor deposition) qu'il soit classique, sous pression réduite connu sous le sigle LPCVD (low pressure chemical vapor deposition) ou assisté par plasma connu sous le sigle PECVD (plasma enhanced chemical vapor deposition), par dépôt physique en phase gazeuse connu sous le sigle PVD (pour physical vapor deposition), par électrolyse, par épitaxie, par oxydation thermique, par dépôt sous vide. Quant au collage, on peut citer le collage moléculaire (connu sous l'acronyme anglo-saxon SDB pour silicon direct bonding c'est-à-dire soudure directe silicium sur silicium), la soudure eutectique, le collage organique, le collage anodique.

Sur la figure 1B, on a montré une couche de flambage 6 monocouche et à adhérence limitée. Cela signifie qu'au niveau de la zone centrale 4 son adhérence est plus faible que celle qu'elle possède au niveau de la zone d'ancrage 3. Son adhérence dans la zone centrale 4 est trop faible pour s'opposer au flambage.

La réalisation du flambage est liée à la fois aux matériaux utilisés pour la couche de flambage 6 et aux applications visées. L'objectif est qu'à l'issue du flambage, une cavité 7 soit formée autour du composant 5. La couche de flambage 6 ne doit donc plus être en contact avec le composant 5 afin de ne pas perturber son fonctionnement. Lorsque le composant est un microsystème 5 comportant une partie active apte à se déplacer, il est important de ne pas entraver son mouvement. De la même manière, il est souhaitable que la couche de flambage 6 ne laisse pas de résidu sur la partie active du microsystème 5. Il est aussi souhaitable que le capot 1 ainsi formé ait une résistance mécanique adaptée au composant 5 et à son utilisation. De plus, on peut vouloir que l'intérieur de la cavité 7 soit soumis au vide ou à une atmosphère contrôlée et en conséquence le capot 1 doit être hermétique.

On va maintenant s'intéresser à des couches de flambage 6 multicouche. Sur les figures 2A à 2D on va réaliser un capot 1 à partir d'un empilement de deux sous-couches 6.1, 6.2 de flambage qui sont toutes les deux en contact avec le substrat 2 lors de la formation et après flambage.

On dépose, dans un premier temps, une première sous-couche de flambage 6.1 sur la zone centrale 4 et la zone d'ancrage 3 (figure 2A). Cette première sous-couche 6.1 a une première adhérence limitée de manière à pouvoir résister à au moins une étape de lithographie et de gravure. On délimite le contour de la première sous-couche de flambage 6.1 par photolithographie et gravure (figure 2B) de manière à ce qu'elle recouvre la zone centrale 4 mais n'empiète quasiment pas sur la zone d'ancrage 3. La gravure peut être faite par tout moyen connu de l'homme du métier et elle dépend de la nature de la première sous-couche 6.1.

On dépose ensuite sur la première sous-couche 6.1 ainsi délimitée une seconde sous-couche 6.2 réalisée dans un matériau à plus forte adhérence que celle du matériau de la première sous-couche 6.1 (figure 2C). La seconde sous-couche 6.2 est en contact avec le substrat 2 au niveau de la zone d'ancrage 3, elle déborde autour de la première sous-couche 6.1.

On fait ensuite flamber la couche de flambage 6 bicouche (figure 2D) jusqu'à ce qu'une cavité 7 de volume adéquat soit obtenue. La couche de flambage 6 une fois flambée devient le capot 1.

Il est possible que l'une des sous-couches de la couche de flambage 6, ayant une de ses faces exposée à l'intérieur de la cavité 7, comme la première sous-couche 6.1 des figures 2 ait une fonction de getter. Des alliages à base de titane, de zirconium peuvent être utilisés. Une telle sous-couche 6.1 est avantageuse lorsque l'intérieur de la cavité 7 doit fonctionner sous vide.

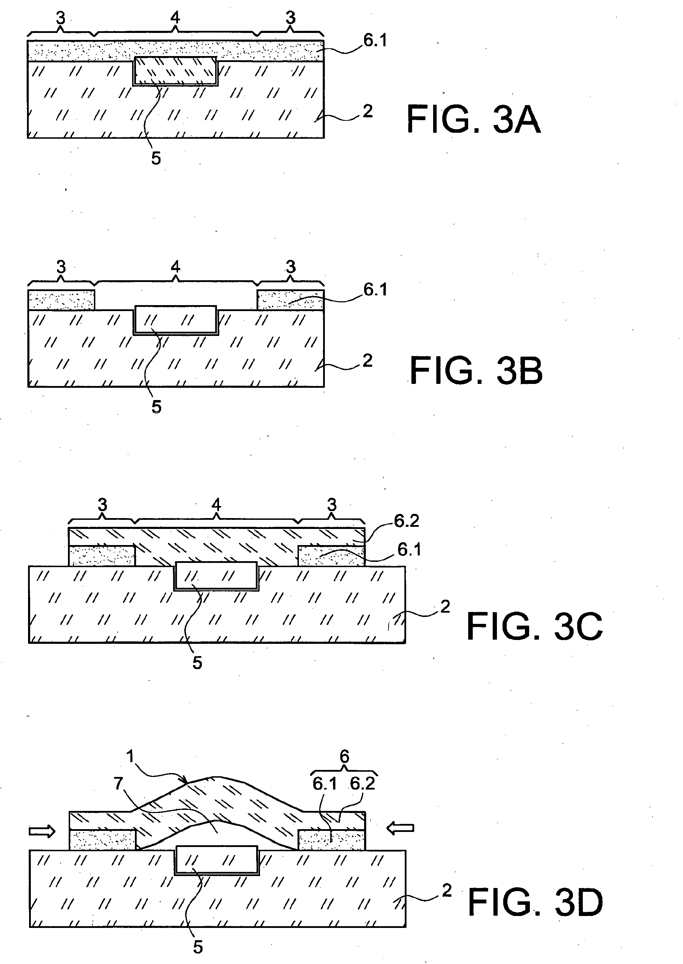

Sur les figures 3A à 3D, on a représenté une variante de capot 1 à deux sous-couches 6.1, 6.2. On dépose une première sous-couche 6.1 sur la zone d'ancrage 3 et la zone centrale 4 du substrat 2 (figure 3A). Cette première sous-couche 6.1 a une bonne adhérence sur le substrat 2 au niveau de la zone d'ancrage 3. On délimite par photolithographie et gravure le contour de la première sous-couche 6.1 de manière à ce qu'elle se trouve sur la zone d'ancrage 3 et n'empiète pas sur la zone centrale 4 (figure 3B). On dépose une seconde sous-couche 6.2 sur la première sous-couche 6.1 ainsi délimitée (figure 3C). La seconde sous-couche 6.2 vient en contact avec le substrat 2 au niveau de la zone centrale 4. La seconde sous-couche 6.2 est réalisée dans un matériau ayant une adhérence inférieure à celle du matériau de la première sous-couche 6.1. On fait ensuite flamber la couche de flambage 6 qui est un empilement des deux sous-couches 6.1, 6.2 (figure 3D) jusqu'à ce qu'une cavité 7 de volume adéquat soit obtenue.

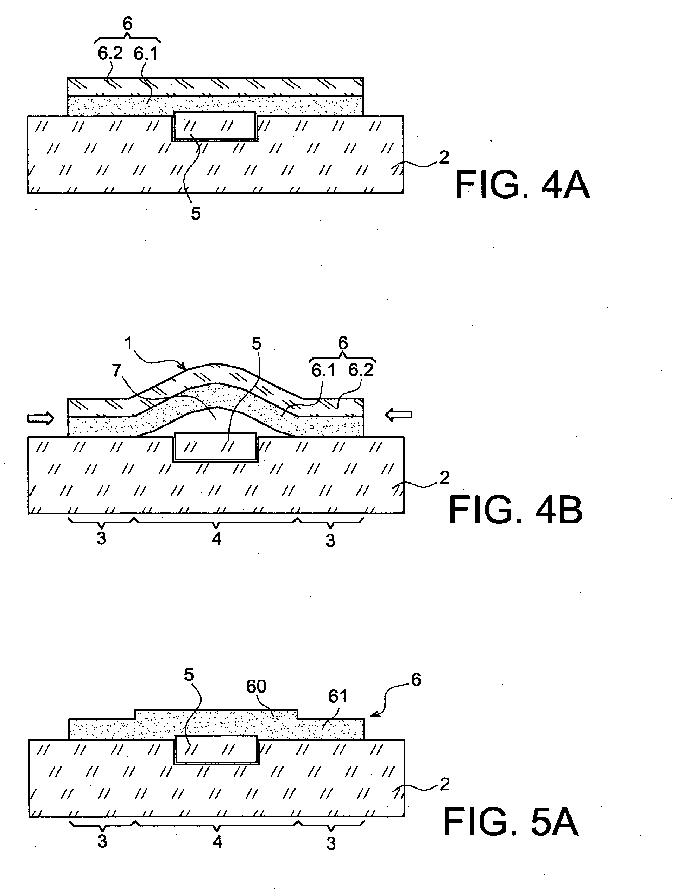

On peut bien sûr envisager qu'il n'y ait qu'une seule sous-couche qui soit en contact avec le substrat 2. On se réfère aux figures 4A, 4B sur lesquelles on ne prévoit que deux sous-couches 6.1, 6.2. On dépose successivement la première sous-couche 6.1, la seconde sous-couche 6.2, seule la première sous-couche 6.1 vient en contact avec le substrat 2 au niveau à la fois de la zone d'ancrage 3 et de la zone centrale 4 (figure 4A). Ensuite on fait flamber la couche de flambage 6 qui est un empilement des deux sous-couches 6.1, 6.2 (figure 4B) jusqu'à ce qu'une cavité 7 de volume adéquat soit obtenue.

Il n'est pas nécessaire que la seconde sous-couche 6.2 ait des propriétés d'adhérence aussi bonnes que celles de la première sous-couche 6.1. L'objectif de cette configuration peut être d'améliorer la tenue en flexion du capot 1 ou l'optimisation de son herméticité dans le cas où celle-ci est nécessaire.

Il est possible que la couche de flambage 6 ou l'une au moins des sous-couches 6.1, 6.2 lorsque la couche de flambage 6 possède plusieurs sous-couches, soit structurée. La structuration est une mise en forme de la couche de flambage ou de l'une de ses sous-couches avant ou après le dépôt de la couche en question sur le substrat muni du microsystème. Cette mise en forme consiste à modifier une sous-couche initiale d'épaisseur constante et à faces sensiblement parallèles en une sous-couche d'épaisseur variable et/ou à faces non parallèles. Le terme structuration implique une opération spécifique sur la sous-couche initiale et n'est pas relié à l'effet induit par la topologie du substrat comportant le microsystème d'accueil. On précise que sur les figures 2A à 2D la sous-couche 6.2 que l'on forme n'est pas structurée.

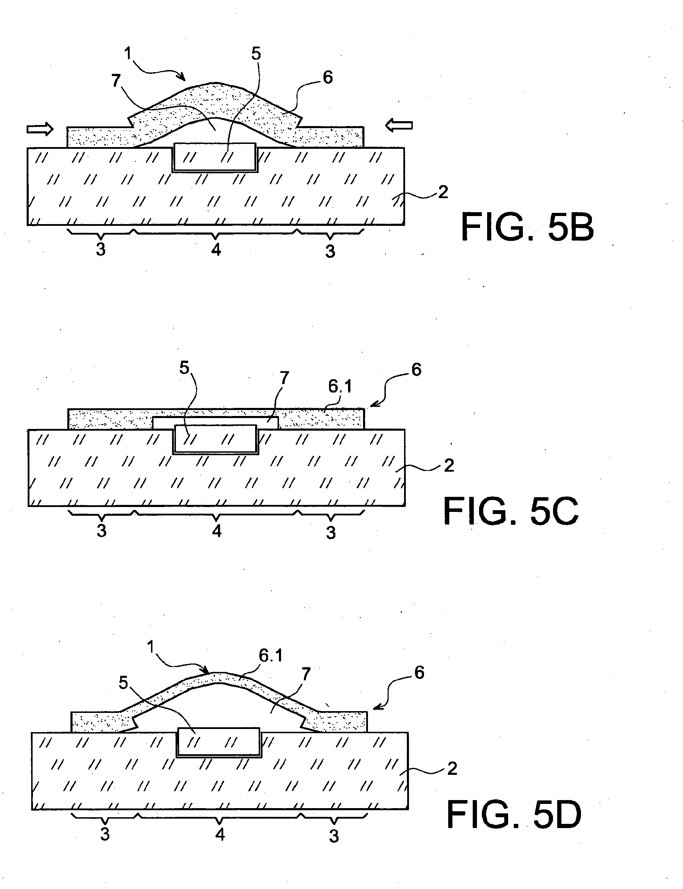

La réalisation de la structuration peut se faire avant ou après l'étape de flambage. La structuration peut être réalisée depuis l'une ou l'autre des faces principales de la couche de flambage 6. Sur les figures 5A, 5B, la zone la plus épaisse 60 de la couche de flambage 6 se trouve au dessus du composant 5 dans la zone centrale 4, la zone la moins épaisse 61 se trouve au niveau de la zone d'ancrage 3. La différence d'épaisseur résultant de l'opération de structuration a été obtenue depuis la face de la couche de flambage 6 opposée au substrat 2, par exemple par un procédé de pressage à chaud (connu sous l'expression hot embossing en anglais). Sur la figure 5B, le capot structuré 1 est réalisé.

Sur les figures 5C, 5D, la zone la moins épaisse 61 de la couche de flambage 6 se trouve au dessus du composant 5 dans la zone centrale 4, la zone la plus épaisse 60 se trouve au niveau de la zone d'ancrage 3. La différence d'épaisseur a été obtenue depuis la face de la couche de flambage 6 se trouvant du côté du substrat 2. Sur la figure 5D, le capot structuré 1 est réalisé.

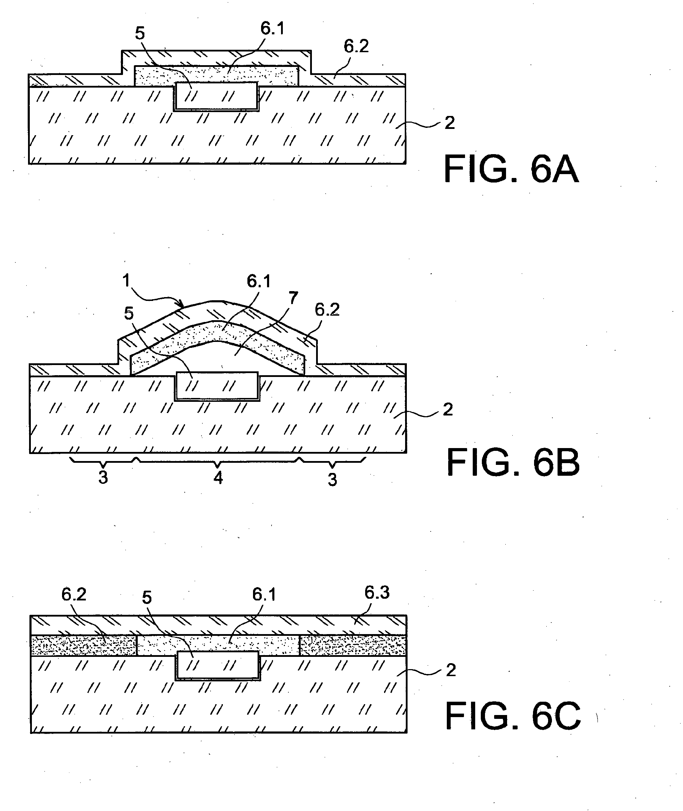

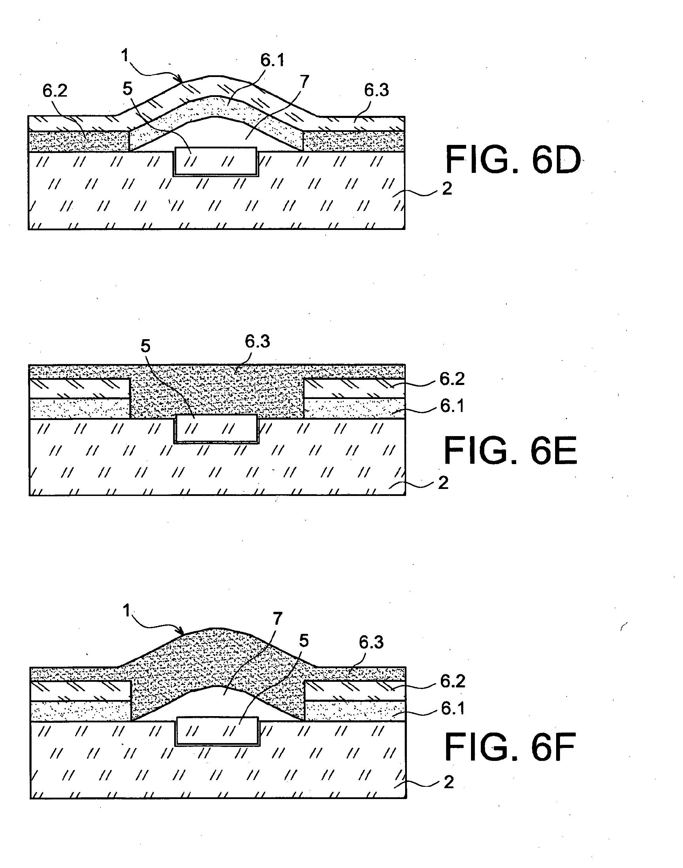

A partir des quatre configurations présentées aux figures 2 à 5, des combinaisons peuvent être faites comme illustré aux figures 6A à 6F. Sur les figures 6A, 6B, la couche de flambage 6 comporte deux sous-couches 6.1, 6.2 dont une seule 6.2, la plus éloignée du substrat 2 au niveau de la zone centrale 4, est en contact avec le substrat 2 au niveau de la zone d'ancrage 3. Sur les figures 6C, 6D, il y a trois sous-couches 6.1, 6.2, 6.3 dont deux, côté substrat 2, sont voisines au lieu d'être superposées, l'une (référencée 6.2) étant au niveau de la zone d'ancrage 3 et l'autre (référencée 6.1) étant au niveau de la zone centrale 4. La troisième sous-couche 6.3, la plus éloignée du substrat 2 s'étend sur les deux premières sous-couches 6.1, 6.2.

Sur les figures 6E, 6F, il y a trois sous-couches 6.1, 6.2, 6.3, superposées uniquement, au niveau de la zone d'ancrage 3. Les deux premières sous-couches 6.1, 6.2 ne s'étendent qu'au niveau de la zone d'ancrage 3. La première sous-couche 6.1 est plus proche du substrat 2 que la deuxième sous-couche 6.2. Au niveau de la zone centrale 4, il n'y a que la troisième sous-couche 6.3. La troisième sous-couche 6.3 est aussi superposée à la première sous-couche 6.1 et à la deuxième sous-couche 6.2 au niveau de la zone d'ancrage 3. L'épaisseur de la couche de flambage 6 est sensiblement constante.

Une configuration tricouche en matériaux différents est intéressante car on peut adapter l'adhérence du matériau de l'une des sous-couches avec celui de l'une au moins des autres sous-couches. On peut bien sûr envisager de prévoir un traitement de surface sur l'une des sous-couches ou sur une partie de l'une des sous-couches de manière à modifier l'adhérence d'une autre sous-couche qui la recouvrira totalement ou partiellement.

Par exemple, sur les figures 6E et 6F, il est possible que la sous-couche intermédiaire 6.2 ait une bonne adhérence avec la première sous-couche 6.1 et que la troisième sous-couche 6.3 ait également une bonne adhérence avec la sous-couche intermédiaire 6.2. En son absence, l'adhérence entre la première sous-couche 6.1 et la troisième sous-couche 6.2 n'aurait pas été suffisante.

Sur les figures 6C, 6D, la seconde sous-couche 6.2 peut avoir un rôle de renforcement de l'adhérence qu'aurait la troisième sous-couche 6.3 sur le substrat 2 alors que la première sous-couche 6.1 peut avoir un rôle de renfort de la résistance mécanique du capot 1 par rapport à celle qu'aurait le capot 1 si il était fait de la troisième sous-couche 6.3 seule. Ainsi toutes les sous-couches n'ont donc pas forcément un rôle de tenue mécanique du capot 1.

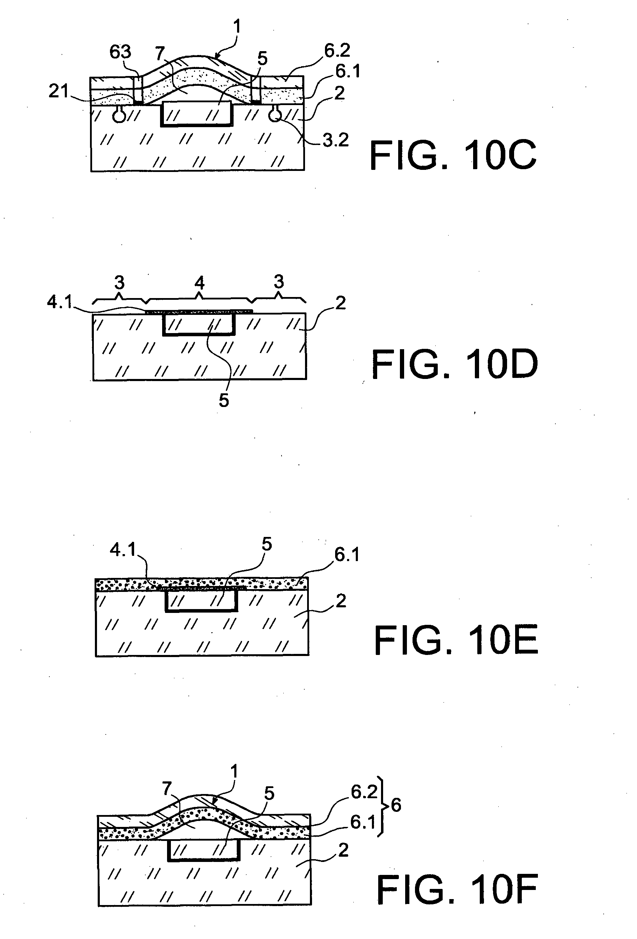

Les sous-couches ayant un rôle à jouer sur la tenue mécanique du capot 1 auront des épaisseurs comprises entre quelques micromètres et quelques dizaines de micromètres pour les matériaux d'origine minérale ou métallique. L'épaisseur de ces sous-couches est conditionnée par les vitesses de dépôt et de gravure. Une étape de gravure est généralement prévue dans le capot 1 pour accéder à des plots de contact électrique 21 associés au composant 5 comme illustré sur la figure 10C.

Les sous-couches en matériau organique dont le rôle est déterminant pour la tenue mécanique du capot 1, pourront avoir des épaisseurs comprises entre quelques micromètres et quelques centaines de micromètres. Si la sous-couche a un rôle à jouer sur l'adhérence de la couche de flambage et pas un rôle mécanique, comme par exemple la seconde sous-couche 6.2 des figures 6E et 6F, son épaisseur pourra être inférieure au micromètre quelle que soit sa nature.

On va voir maintenant comment faire flamber la couche de flambage 6. Pour que le flambage puisse avoir lieu, il faut que la couche de flambage 6 soit maintenue sous contrainte localement. Cette contrainte peut être une compression. Le flambage peut être obtenu par traitement thermique. La contrainte peut être induite par le substrat 2 lui-même.

On s'arrange pour que la couche de flambage 6, si elle est monocouche, ait un coefficient de dilatation thermique qui soit inférieur au coefficient de dilatation thermique du substrat 2 ou si elle est multicouche, comporte au moins une sous-couche 6.2 ayant un coefficient de dilatation thermique qui soit inférieur au coefficient de dilatation thermique du substrat 2. Par contre, lorsqu'il s'agit d'une sous-couche, elle aura une rigidité plus grande que celle du reste de la couche de flambage 6. Cela signifie que son épaisseur et son module d'Young seront supérieurs à ceux du reste de la couche de flambage 6. De préférence, la sous-couche à faible coefficient de dilatation thermique est déposée en premier. Il est possible de prévoir une sous-couche ayant une fonction d'abaissement de l'adhérence dans la zone centrale 4.

Pour une couche de flambage monocouche, plus sa rigidité est faible, moins sa résistance est grande.

Le flambage peut avoir lieu lors du dépôt de la couche de flambage ou de la sous-couche, dans la mesure où le dépôt se fait à une température appropriée.

Il existe trois possibilités avec des sous-couches. Le flambage peut avoir lieu pendant le dépôt de la sous-couche à faible coefficient de dilatation thermique, si elle est suffisamment en compression par rapport à l'adhérence de la zone centrale 4. Le flambage peut avoir lieu pendant le dépôt d'une autre sous-couche ayant un plus fort coefficient de dilatation thermique, la contrainte de compression augmentant alors dans la sous-couche à plus faible coefficient de dilatation thermique. Le flambage peut avoir lieu après le dépôt de la couche de flambage en effectuant un traitement thermique sous vide, par exemple à environ 300°C pendant environ 10 minutes. Il s'agit alors d'un cas où la dégradation de la sous-couche déposée en premier est partielle. Cette-ci reste accrochée à la couche de flambage. Lors du traitement thermique elle dégaze. Une pression se crée et puisque l'ensemble est maintenu sous vide, des cloques se forment à l'interface entre la couche de flambage et le substrat dans la zone centrale 4, favorisant alors le décollement de la couche de flambage.

Il est possible en variante que la dégradation de la sous-couche déposée en premier soit totale par évaporation à une température inférieure à environ 100°C par exemple pour une sous-couche liquide d'eau, de carbonate de propylène ou une sous-couche solide d'Unitic.

Le niveau de contrainte est donné par la formule suivante : $\sigma = E.\Delta T.\Delta\alpha$

avec $\sigma$ contrainte dans la couche ou la sous-couche, $\Delta T$ différence de température entre la température de dépôt de la couche ou de la sous-couche et la température ambiante, $\Delta\alpha$ différence entre le coefficient de dilation thermique du substrat et le coefficient de dilatation thermique de la couche ou de la sous-couche. La température de dépôt de la couche ou de la sous-couche à faible coefficient de dilatation thermique doit être optimisée non seulement pour obtenir une qualité de dépôt recherchée mais aussi pour déclencher le phénomène de flambage en procurant le niveau de contrainte requis. Par exemple en se référant à la figure 5D, on peut réaliser la couche de flambage 6 en oxyde de silicium $SiO_2$ et le substrat 2 en silicium. Le coefficient de dilatation thermique de l'oxyde de silicium vaut environ $0,5.10^{-6}$ mm/K et celui du silicium environ $2,6.10^{-6}$ mm/K.

Comme autre exemple, en se référant à la figure 2D, la couche de flambage 6 peut être formée d'une première sous-couche 6.1 en parylène surmontée d'une deuxième sous-couche 6.2 en oxyde de silicium alors que le substrat 2 est en silicium. La première sous-couche 6.1 est destinée à garantir la différence d'adhérence recherchée notamment au niveau de la zone centrale 4 et la seconde sous-couche 6.2 a un rôle mécanique, c'est elle qui adhère au substrat 2 et de plus elle contribue à déclencher le phénomène de flambage à cause de son coefficient de dilatation thermique qui est inférieur à celui du substrat 2.

En variante, il est possible que la contrainte de compression soit induite au sein de la couche de flambage 6 au lieu du substrat 2. Dans cette configuration, la couche de flambage 6 est multicouche et comporte au moins une sous-couche ayant un coefficient de dilatation thermique supérieur à celui d'une autre sous-couche de la couche de flambage.

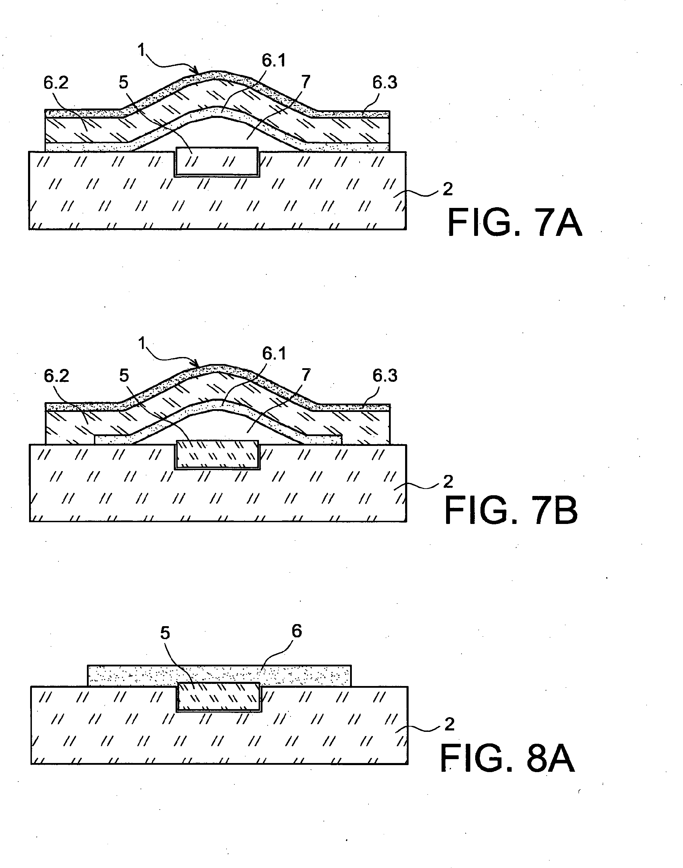

Dans l'exemple illustré à la figure 7A, la couche de flambage 6 est tricouche avec, depuis le substrat 2, une première sous-couche 6.1 en matériau organique, destinée à assurer un découplage mécanique entre le substrat 2 et la couche de flambage 6, une seconde sous-couche 6.2 intermédiaire ayant un coefficient de dilatation thermique et une troisièmes sous-couche 6.3 ayant un coefficient de dilatation thermique supérieur à celui de la seconde sous-couche 6.2. Seule la première sous-couche 6.1 est en contact avec le substrat 2. Elle est choisie pour ses propriétés d'adhérence. Plus la surface de contact dans la zone d'ancrage 3 est grande, plus le risque de fuite est limité.

La première sous-couche 6.1 peut être par exemple en parylène, benzocyclobutène, polyéthylène téréphtalate. La seconde sous-couche 6.2 peut être en oxyde de silicium et la troisième sous-couche 6.3 en nitrure de titane TiN, en nitrure de silicium $Si_3N_4$, en cuivre Cu. Les coefficients de dilatation thermique de ces trois derniers matériaux métallique ou minéraux sont plus élevés que celui de l'oxyde de silicium. La mise en compression est essentiellement assurée par la troisième sous-couche 6.3, la première sous-couche 6.1 faisant office de découplage mécanique avec le substrat 2.

En variante, la contrainte de compression peut provenir d'un cumul entre la contrainte induite par le substrat 2 et la contrainte induite par l'une des sous-couches après son dépôt. On peut se référer à la figure 7B. La première sous-couche de flambage 6.1 en matériau organique, configurée comme sur la figure 2D a pour rôle de garantir une différence d'adhérence recherchée notamment au niveau de la zone centrale 4.

La deuxième sous-couche 6.2 vient en contact direct avec le substrat 2 au-delà de la première sous-couche 6.1. Elle est de même nature que celle illustrée à la figure 7A. La troisième sous-couche 6.3, de même nature que celle illustrée à la figure 7A, a un coefficient de dilatation thermique supérieur à celui de la deuxième sous-couche 6.2.

Selon un autre mode de réalisation, le flambage peut être obtenu d'une part par l'utilisation d'au moins un élément de compression 8 additionnel pour réaliser la mise sous contrainte et d'autre part par traitement thermique pour engendrer le flambage. L'élément de compression 8 est localisé à la périphérie de la couche de flambage 6 au niveau de la zone d'ancrage 3. L'élément de compression 8 surmonte la couche de flambage 6 et éventuellement empiète sur le substrat 2 autour de la couche de flambage 6. Lorsqu'il y a plusieurs éléments de compression 8, ils forment une couronne discontinue le long du bord de la couche de flambage 6. Lorsqu'il y a une couronne continue et donc un seul élément de compression 8, c'est l'élément de compression 8 qui réalise l'étanchéité.

On adapte le coefficient de dilatation thermique de l'élément de compression 8, à celui de la couche de flambage 6 et éventuellement à celui du substrat 2 dans la mesure où l'élément de compression 8 surmonte le substrat 2. La nature de l'élément de compression 8 détermine le couplage mécanique entre ce dernier et la couche de flambage 6 et/ou le substrat 2. L'élément de flambage 8 est obtenu par dépôt, la température de dépôt étant déterminante dans la mesure où elle est directement reliée au niveau de contrainte à induire sur la couche de flambage 6. Plus elle est élevée, plus la contrainte est importante, toutes choses étant égales par ailleurs.

On se réfère aux figures 8A à 8C. Sur la figure 8A seule la couche de flambage 6 est déposée. On suppose qu'elle est monocouche et par exemple en oxyde de silicium. Le substrat 2 est par exemple en silicium. Après dépôt de la couche de flambage 6, celle-ci est naturellement en compression puisque son coefficient de dilatation thermique est inférieur à celui du substrat 2.

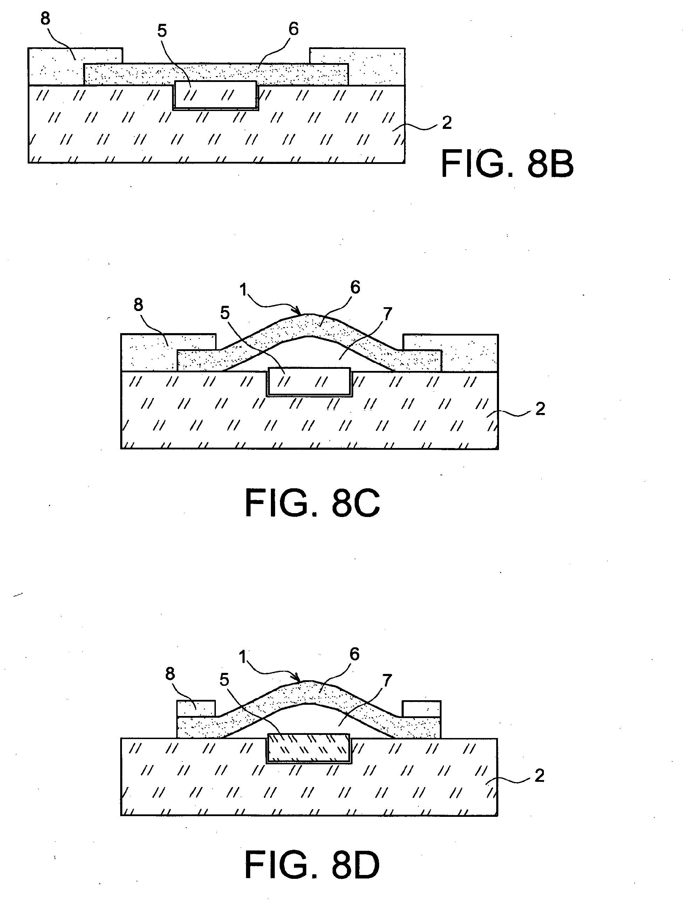

Pour augmenter la mise en compression, on dépose, en périphérie de la couche de flambage 6, un élément de compression 8, qui dans l'exemple s'étend à la fois sur la couche de flambage 6 et sur le substrat 2 (figure 8B). Le matériau de l'élément de compression 8 aura une rigidité supérieure à celle de la couche de flambage 6 et un coefficient de dilatation thermique également supérieur à celui de la couche de flambage 6 ou à celui d'au moins une des sous-couches de la couche de flambage si la couche de flambage est multicouche. Avantageusement, le matériau de l'élément de compression aura un coefficient de dilatation thermique supérieur à celui de la plupart des sous-couches de la couche de flambage. En fait, il est difficile de réaliser une couche de flambage multicouche dont toutes les sous-couches ont un coefficient de dilatation thermique inférieur à celui de l'élément de compression. Avantageusement, le coefficient de dilatation thermique de l'élément de compression sera supérieur à celui de la sous-couche la plus rigide.

Une optimisation de la géométrie de l'élément de compression 8 peut être obtenue, la géométrie dépendant de la géométrie de la couche de flambage 6, de celle de la zone d'ancrage 3 et du niveau de contrainte recherché.

Par un traitement thermique ultérieur, on induit le flambage de la couche de flambage (figure 8C), elle est maintenue en compression par l'élément de compression 8 et par le substrat 2. Dans ce cas le flambage n'est pas obtenu lors de la formation de la couche de flambage mais après, lors du dépôt de l'élément de compression 8, ce dépôt se faisant en température.

L'élément de compression 8 peut être réalisé en un matériau minéral tel que le nitrure de silicium $Si_3N_4$ (module d'Young de 310 GPa et coefficient de dilatation thermique de $3,4.10^{-6}$ mm/K) ou mieux le nitrure de titane TiN (module d'Young de 600 GPa et coefficient de dilatation thermique de $9,4.10^{-6}$ mm/K). Un matériau métallique peut également être employé comme le cuivre Cu qui a un coefficient de dilatation thermique encore plus élevé (module d'Young de 130 GPa et coefficient de dilatation thermique de $17.10^{-6}$ mm/K). La rigidité moindre du cuivre peut être compensée en accroissant l'épaisseur de l'élément de compression 8.

Sur la figure 8D, on a représenté un exemple d'élément de compression 8 qui n'empiète pas sur le substrat 2. On suppose qu'il est réalisé en nitrure de titane TiN. Il est localisé en périphérie de la couche de flambage 6.

Sur la figure 8E, on a représenté une couche de flambage 6 bicouche avec une première sous-couche 6.1 surmontée par une seconde sous-couche de flambage 6.2. La première sous-couche 6.1 est en matériau organique qui apporte une différence d'adhérence requise entre le substrat 2 et le reste de la couche de flambage 6. Cette première sous-couche de flambage 6.1 assure un découplage mécanique entre le substrat 2 et la couche de flambage 6. Elle possède un module d'Young faible devant celui de la seconde sous-couche de flambage 6.2 et une épaisseur de quelques micromètres. Elle peut être par exemple en parylène, en benzocyclobutène, en polyéthylène téréphtalique. La tenue mécanique de la couche de flambage 6 est assurée par la seconde sous-couche de flambage 6.2 qui est plus rigide et dont le coefficient de dilatation thermique est faible devant celui du substrat 2.

L'élément de compression 8 répond aux mêmes exigences qu'exposé dans l'exemple précédent : son coefficient de dilatation thermique est supérieur au moins à celui de la seconde sous-couche 6.2 et son module d'Young est supérieur à ceux de la première et seconde sous-couche 6.1, 6.2. La première sous-couche 6.1 dépasse de la seconde sous-couche 6.2 et l'élément de compression 8 s'étend en périphérie de la couche de flambage 6 à la fois sur la première et la seconde sous-couche 6.1, 6.2 mais pas sur le substrat 2.

Sur la figure 8F, on a représenté un mode de réalisation dans lequel au moins uns sous-couche 6.1 de la couche de flambage 6 s'étend sur plusieurs microsystèmes 5.

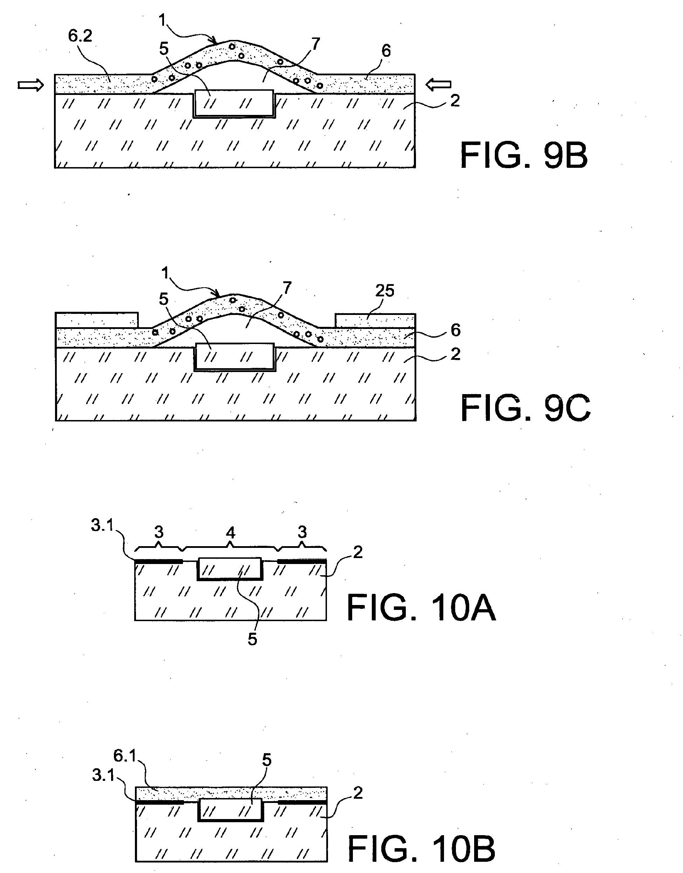

Selon encore un autre mode de réalisation, le flambage peut être obtenu par implantation ionique localisée dans la couche de flambage 6. On se réfère aux figures 9A, 9B. L'implantation ionique se fait au niveau de la zone centrale 4 et la zone d'ancrage 3 est épargnée. Les ions implantés dans la couche de flambage 6 induisent une contrainte interne de compression dans cette couche de flambage 6. Cette contrainte de compression est à l'origine du flambage. On peut se référer à l'article « Crack-arresting compression layers produced by ion implantation », V. N. Gurarie et al., Nuclear Instruments And Methods In Physics Research, B242 (2006), pages 421-423. L'importance de la contrainte de compression dépend de la dose implantée et de la nature des ions utilisés. Sur la figure 9B, on a représenté la couche de flambage 6 après flambage. Il est possible d'effectuer un traitement thermique optionnel pour favoriser le flambage de la couche de flambage 6 à une température supérieure à environ 200°C pour activer le phénomène de flambage.

On se place dans le cas où le coefficient de dilatation thermique de la couche de flambage 6 est supérieur au coefficient de dilatation thermique du substrat 2. A l'issue du dépôt de la couche de flambage 6, celle-ci est naturellement en tension. Pour activer le flambage, il faut mettre cette couche en compression. Nécessairement le mode d'activation ne peut être thermique. Si l'on utilise un procédé d'implantation ionique, la dose et les éléments à implanter sont choisis pour contrebalancer la tension que possède la couche de flambage après le dépôt de manière à la mettre en compression au-delà de la contrainte critique de flambage. Avantageusement l'homme du métier choisira l'espèce à implanter par rapport à son poids, sa nature (anion ou cation) de façon que sa position dans le réseau cristallographique de la couche de flambage soit telle qu'elle induise une contrainte en compression maximale. Par essais successifs, l'homme du métier adoptera une dose permettant d'atteindre la contrainte critique en compression.

Avantageusement la couche de flambage 6 pourra être une céramique telle que le nitrure de silicium $Si_3N_4$ ou l'alumine $Al_2O_3$.

Une seule étape d'implantation ionique permet d'obtenir le flambage. Lorsque le flambage a été obtenu par implantation ionique et que des traitements thermiques supplémentaires sont requis, par exemple lors de l'injection plastique lors de l'enrobage du capot, la couche de flambage possède une tenue mécanique améliorée par rapport aux cas où le flambage n'est pas obtenu par implantation ionique. En effet, lors d'une montée en température ultérieure, la couche de flambage 6 ayant un coefficient de dilatation thermique supérieur à celui du substrat 2, la compression interne augmente et la tenue en flexion se trouve améliorée.

Si on se place dans le cas où le coefficient de dilatation thermique de la couche de flambage 6 est inférieur au coefficient de dilatation thermique du substrat 2. Elle peut être en oxyde de silicium ou en silicium polycristallin.

A l'issue du dépôt de la couche de flambage, celle-ci est naturellement en compression et est susceptible d'avoir déjà une contrainte interne supérieure à la contrainte critique de flambage si la température de dépôt est suffisante. Si toutefois l'effet du dépôt n'est pas suffisant, un complément d'activation du flambage pourra être réalisé par implantation ionique ou écrouissage plasma.

Par ailleurs, le dispositif obtenu peut ensuite être soumis à des étapes d'assemblage mettant en oeuvre des procédés impliquant des températures supérieures à environ 100°C. Afin de maintenir la rigidité mécanique du capot, il est avantageux de réaliser préalablement une couche apte à conserver ou à augmenter la rigidité du capot 1.

Pour cela, après flambage, un revêtement additionnel 25 en matériau à faible coefficient de dilatation thermique, comme l'oxyde de silicium $SiO_2$ ou le silicium polycristallin, est déposé sur la couche de flambage 6, il peut être localisé seulement en périphérie de la couche de flambage 6 (figure 9C) et prendre la forme d'une couronne ou s'étendre sur toute la couche de flambage 6. Le dépôt de ce revêtement additionnel 25 ne doit pas avoir un impact sur le flambage réalisé, mais il est destiné à accentuer ou conserver la contrainte de compression dans la couche de flambage 6 lors d'un traitement thermique ultérieur à une température supérieure à environ 100°C.

En variante, il est possible de réaliser le flambage par dépôt de la couche de flambage ou d'au moins une sous-couche de la couche de flambage par épitaxie sous contrainte. Par exemple, la couche ou la sous-couche déposée par épitaxie peut être en silicium-germanium et le substrat ou la sous-couche d'accueil étant en silicium.

Encore une autre variante consiste à faire subir à la couche de flambage ou à l'une de ses sous-couches un écrouissage sous plasma. Ces étapes ne peuvent être représentées spécifiquement. Un certain nombre de figures représentent le flambage et on suppose que ces moyens pour obtenir le flambage sont représentés sur ces figures.

Les modes de mise en compression de la couche de flambage que l'on vient de décrire (implantation ionique, écrouissage plasma mais aussi dépôt par épitaxie sous contrainte) peuvent aussi s'appliquer aux éléments de compression 8 pour renforcer la compression. En outre, un traitement thermique peut être couplé aux modes de mise en compression. Les éléments de compression 8 peuvent être multicouche avec des matériaux ayant des coefficients de dilatation différents.

On va s'intéresser maintenant à la zone d'ancrage 3. La zone d'ancrage 3 sert à contenir le flambage. Sa géométrie doit être reproductible. Elle doit conserver ses propriétés, dans le temps, de manière que l'ancrage du capot 1 au substrat 2 ne se détériore pas. Elle peut contribuer à assurer l'étanchéité du capot 1.

L'ancrage peut être défini par l'adhérence du substrat 2 vis-à-vis du matériau de la couche de flambage 6 qui viendra en contact avec le substrat 2. On peut se reporter à la description des figures 2. Il est toutefois possible de définir, préalablement à la formation de la couche de flambage 6, la zone d'ancrage 3. On recherche au niveau de cette zone d'ancrage 3 une adhérence plus importante que celle existant au niveau de la zone centrale 4.

On peut ainsi procéder à un traitement ou à un dépôt 3.1 sur la zone d'ancrage 3 de manière à améliorer l'adhérence de la couche de flambage 6 sur le substrat 2 comme illustré à la figure 10A. Ce dépôt peut être un dépôt de colle avant le laminage d'un film 6.1 formant une sous-couche de la couche de flambage ou la couche de flambage (figure 10B). Le film 6.1 peut lui aussi être formé d'un empilement de sous films solidarisés par de la colle ou par adhésion directe lors du dépôt du ou des sous films supérieurs si le matériau le permet en adaptant de manière appropriée la pression et la température de dépôt.

En variante, après le dépôt de colle, on peut rapporter un autre substrat comme on le verra ultérieurement, cet autre substrat pouvant être ultérieurement aminci.

Au lieu de procéder à un dépôt de colle, on peut procéder au dépôt d'un primaire d'adhérence approprié à la couche de flambage ou à la première sous-couche de la couche de flambage à coller, dans le cas où cette dernière est organique. Cette façon de procéder convient bien à une première sous-couche de découplage mécanique, comme celle référencée 6.1 sur la figure 7A. Une couche de flambage totalement organique ne conviendrait pas à cause de ses pauvres propriétés mécaniques.

En variante, au lieu de coller la couche de flambage 6 au substrat 2, il est possible de la souder par soudure eutectique, par collage anodique, la figure 10B, pouvant également représenter cette variante, ce qui permet de ne pas multiplier inutilement le nombre de figures.

On peut ainsi assembler deux substrats 2, 20 en silicium dont un va réaliser la couche de flambage et l'autre le substrat. Le mélange eutectique 3.1 est déposé sur la zone d'ancrage 3 du premier substrat 2 ou sur la second substrat 20. On rappelle qu'un eutectique est un mélange de substances dont le point de fusion est de loin inférieur au point de fusion des substances constituant le mélange. Des exemples de soudure eutectique seraient des mélanges or silicium AuSi ou or étain AuSn.

Un exemple de traitement à appliquer à la zone d'ancrage 3 pour améliorer l'adhérence de la couche de flambage est par exemple d'appliquer un plasma à l'oxygène sur un substrat organique avant d'appliquer une couche de flambage ou une sous-couche de flambage organique. On a la fois une légère rugosité de la surface et une préparation de chimie de surface.

Il est également possible de prévoir au niveau de la zone d'ancrage 3, des points d'ancrage en creux 3.2 dans le substrat 2. On peut se référer à la figure 10C d'une part et d'autre part à l'article « Robust parylene-to-silicon mechanical anchoring » LIGER Matthieu et al, the 16th IEEE International MEMS Conference (MEMS'03), Kyoto, Japan Jan 19-23 2003, pages 602-605. Les points d'ancrage en creux 3.2 peuvent être des puits, des tranchées. Ils sont obtenus par gravure du substrat 2. Le matériau de la couche de flambage ou d'une sous-couche de flambage 6.1 est déposé, il remplit les puits ou les tranchées 3.2 et est ainsi ancré au substrat 2. Sur la figure 10C, on a dessiné en outre, la réalisation dans la couche de flambage 6, d'ouvertures 63 pour avoir accès à des plots de contacts électriques, 21 portés par le substrat 2, destinés à l'alimentation en énergie du composant 5.

On a décrit des moyens pour favoriser l'ancrage entre le substrat 2 et la couche de flambage 6 en améliorant l'adhérence au niveau de la zone d'ancrage 3.

En alternative ou en complément, il est possible de dégrader l'adhérence entre la couche de flambage 6 et le substrat 2 au niveau de la zone centrale 4.

On peut ainsi procéder à un traitement ou à un dépôt sur la zone centrale 4 de manière à dégrader l'adhérence de la couche de flambage 6 sur le substrat 2 comme illustré à la figure 10D avant le dépôt de la couche de flambage 6. Il est possible de déposer localement un matériau intermédiaire 4.1 sur le substrat 2 au niveau de la zone centrale 4 avant le dépôt de la couche de flambage 6. En variante, c'est la couche de flambage 6 qui peut recevoir le dépôt intermédiaire pour que celui-ci se retrouve au niveau de la zone centrale 4 après assemblage au substrat 2. La couche de flambage 6 ne sera alors pas en contact direct avec le composant 5. Une fois la couche de flambage déposée ou partiellement déposée ou assemblée, le matériau intermédiaire 4.1 est évaporé ou détérioré de manière à libérer la couche de flambage 6. Le matériau de la couche intermédiaire 4.1 peut être choisi parmi des matériaux liquides à base d'eau ou parmi les polymères comme par exemple l'Unity 2203 qui est une résine photosensible à base de polycarbonate de la société Promerus, les thiols. Son élimination peut se faire thermiquement. On s'arrange pour qu'aucun résidu ne risque de perturber le fonctionnement du composant 5.

Pour cela on va éliminer les résidus issus de la dégradation thermique ou de l'évaporation en utilisant une première sous-couche de flambage 6.1 poreuse comme illustré sur la figure 10E. On procède ensuite après l'évaporation ou la dégradation au dépôt d'au moins une autre sous-couche 6.2 comme illustré à la figure 10F pour achever la couche de flambage 6.

Après l'étape d'évaporation ou de dégradation, on peut prévoir une nouvelle étape de traitement thermique ou de mise sous pression contrôlée inférieure à environ 10 Pa ($10^{-1}$mbar), typiquement d'environ 0,01 Pa ($10^{-4}$mbar) afin de permettre l'évacuation les plus gros. L'étape de traitement thermique peut être effectuée à une température supérieure à environ 100°C et avantageusement entre environ 100°C et 400°C.

On peut aussi utiliser un matériau peu ou pas adhérent qui forme une sous-couche de la couche de flambage tel que le polytétrafluoroéthylène, les silicones, le parylène, le polydiméthylsiloxane, les résines photosensibles.

Comme traitement visant à dégrader l'adhérence de la zone centrale 4, il est possible d'augmenter la rugosité de la zone centrale 4 par un traitement plasma du substrat 2.

Pour un substrat organique, un plasma d'oxygène peut favoriser et préparer la surface en vue d'un collage organique avec apport de colle. Dans ce cas, on génère une légère rugosité de la surface et une préparation de la chimie de surface.

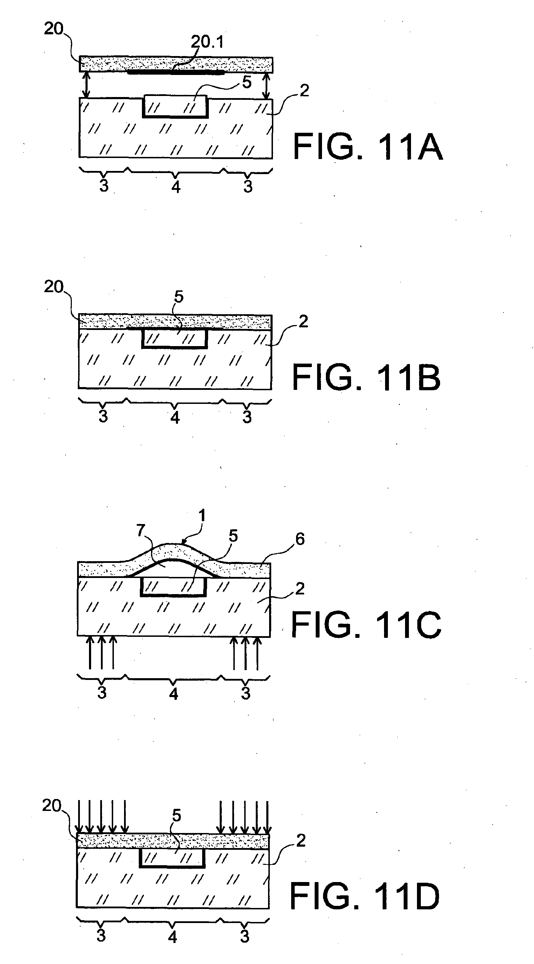

Pour un substrat silicium destiné à subir un collage moléculaire, un plasma plus puissant de type argon ou $SF_6$ peut être utilisé dans la zone centrale 4. En variante, il est possible de traiter par plasma la couche de flambage 6 dans la mesure où elle est issue d'un second substrat 20, en silicium comme le premier référencé 2, qui va être assemblé par collage moléculaire avec le premier substrat 2 au niveau de la zone d'ancrage 3. On se réfère à la figure 11A. On traite par plasma le second substrat 20 pour le rendre rugueux seulement au niveau d'une zone 20.1 qui viendra face à la zone centrale 4 du premier substrat 2. On ne traite pas la partie qui viendra face à la zone d'ancrage 3. Si on assemble le second substrat 20, par collage moléculaire, au premier substrat 2 au niveau de la zone d'ancrage 3, les surfaces à assembler doivent être préparées mais pas trop rugueuses car sinon l'adhésion ne peut avoir lieu.

On peut prévoir un traitement thermique pour renforcer l'assemblage par collage et une étape d'amincissement du second substrat 20 comme illustré à la figure 11B. Le second substrat 20 après amincissement devient la couche de flambage 6 que l'on fait flamber (figure 11C). La rugosité naturelle des deux substrats 2, 20 favorise le collage moléculaire au niveau de la zone d'ancrage 3 lors de l'assemblage. Par contre, la rugosité accrue du second substrat 20 au niveau de la zone 20.1 (ou du premier substrat 2) obtenue par le plasma est incompatible avec le collage moléculaire.

Il est possible de définir la zone d'ancrage 3 postérieurement à la réalisation de la couche de flambage 6 ou en cours de réalisation de la couche de flambage 6 mais dans tous les cas avant le flambage. On peut envisager de faire un apport d'énergie 22 au niveau de la zone d'ancrage 3 ou de la zone centrale 4 selon l'effet recherché. Cet apport d'énergie 22 peut être un rayonnement de longueur d'onde approprié (figure 11D) ou un apport de chaleur. Cet apport d'énergie 22 peut se faire depuis la couche de flambage 6 et/ou depuis le substrat 2. Il peut s'agir d'une fusion localisée par laser d'au moins une sous-couche de la couche de flambage 6 au niveau de la zone d'ancrage 3 ou une fusion obtenue par un rayonnement infrarouge. En variante, une exposition à un rayonnement ultra violet au niveau de la zone d'ancrage 3 va augmenter l'adhérence de la couche de flambage 6 sur le substrat 2.

Une exposition à un rayonnement ultra violet peut désactiver chimiquement l'effet adhérent d'une colle. Par exemple un film adhésif UV de Nitto Denko utilisé pour la découpe de plaquettes de silicium se décolle aisément lorsqu'il a été soumis à des ultra violets.

Bien entendu un tel apport d'énergie 22 localisé peut se combiner au traitement ou au dépôt appliqué sur le substrat 2 ou sur la couche de flambage 6 avant l'assemblage entre couche de flambage 6 et substrat 2 ou avant le dépôt de la couche de flambage 6 sur le substrat 2.

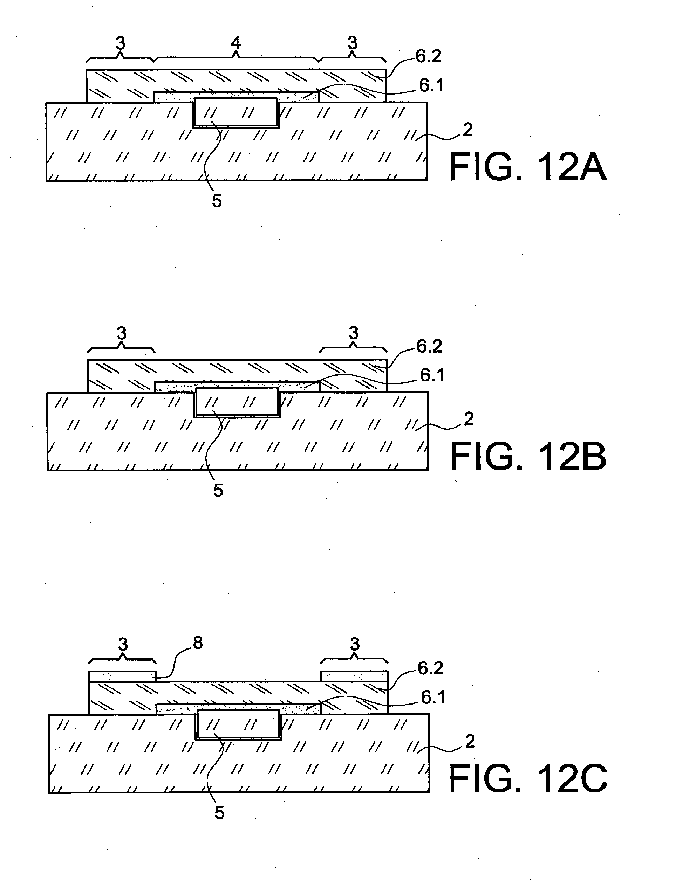

On va maintenant s'intéresser à un mode de réalisation avantageux, destiné à encapsuler des microsystèmes bas coût, à produire avec de gros volumes. Il s'agit par exemple de filtres à ondes acoustiques de volume connus sous le sigle BAW pour Bulk Acoustic Wave) ou de MEMS radiofréquence. On se réfère à la figure 12A. On part d'un substrat de silicium incorporer le microsystème 5. On dépose une sous-couche 6.1 de parylène, par pulvérisation en phase gazeuse sur le substrat 1, elle recouvre le microsystème 5. On délimite son motif par une étape de photolithographie suivie d'une gravure (figure 12A). La délimitation de son motif définit la zone centrale 4. La zone d'ancrage 3 se trouve au-delà de la zone centrale 4. On dépose en surface du substrat 2 une seconde sous-couche de flambage 6.2 en oxyde de silicium. On délimite son motif par une étape de photolithographie suivie d'une gravure (figure 12B). La seconde sous-couche 6.2 dépasse de la première sous-couche 6.1 et vient en contact avec le substrat 2 au niveau de la zone d'ancrage 3. Elle adhère au substrat 2 au niveau de la zone d'ancrage 3. Elle contribue à définir la zone d'ancrage 3.

On peut, de manière facultative déposer une troisième sous-couche (non référencée) qui après une étape de délimitation de motif par photolithographie et gravure donne un ou plusieurs éléments de compression 8, en bordure de la seconde sous-couche 6.2 (figure 12C). Ils s'étendent uniquement au niveau de la zone d'ancrage 3. Ils peuvent être réalisés en nitrure de titane TiN.

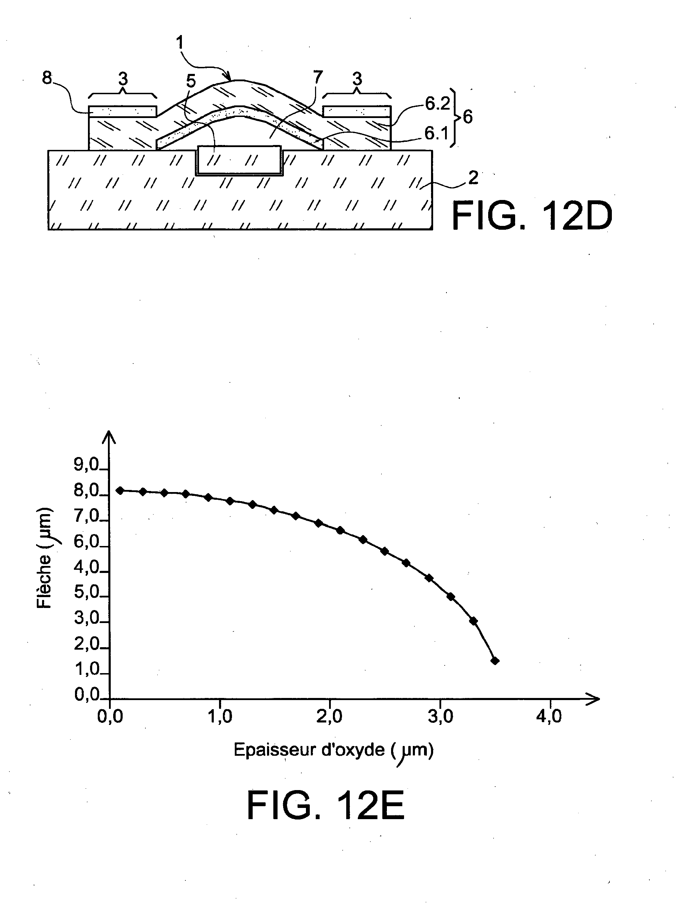

Ensuite on fait flamber la couche de flambage 6 (figure 12D).

La première sous-couche 6.1 de parylène a pour fonction d'empêcher le reste de la couche de flambage 6 d'adhérer sur le substrat 2 au niveau de la zone centrale 4. L'épaisseur de la première sous-couche de flambage 6.1 peut être de quelques dixièmes micromètres à quelques micromètres dans la mesure où elle n'a aucun rôle mécanique. Le parylène est un matériau qui adhère mieux sur l'oxyde de silicium que sur le silicium comme on peut le lire dans le document « Parylene flexible neural probe with micro fluidic channel » de Shoji TAKEUCHI et al., IEEE 2004, pages 208-211. En conséquence il reste solidaire de la seconde sous-couche d'oxyde 6.2 lors du flambage et n'adhère pas au substrat 2.

La seconde sous-couche 6.2 a pour fonction non seulement d'assurer le flambage mais aussi d'assurer la tenue mécanique du capot 1 une fois le flambage obtenu, ainsi que l'ancrage du capot 1 sur le substrat 2.

Des études sur le flambage de membranes sont décrites dans la littérature, par exemple dans les articles "Buckled membranes for microstructures" Dan S. POPESCU et al., 0-7803-1833-1/94 IEEE 1994, pages 188-192 et "Silicon active microvalves using buckled membranes for actuation", Dan S. POPESCU et al., Transducers '95, the 8th International Conference on solid-state sensors and actuators, and Eurosensors IX, Stockholm, Sweden, June 25-29, 1995, pages 305-308. Dans ces études, en fonctionnement, les membranes sont destinées à être mobiles en fonction de la pression qui s'applique sur elles et dans certaines applications sont destinées à passer d'un état à un autre. Les membranes étudiées dans ces études sont ancrées à leur périphérie sur un support ou cadre et leurs deux faces principales sont en contact avec l'air ambiant.

Dans la présente invention, seule une face de la couche de flambage est en contact avec l'air ambiant, l'autre face est en contact avec le substrat avant le flambage mais pas avec l'air ambiant.

La contrainte critique de flambage, c'est-à-dire la contrainte minimale de compression nécessaire pour déclencher le flambage d'une membrane carrée répond à l'équation suivante :

$$\sigma_{cr} = 4{,}38 \times \frac{h^2}{a^2} \times \frac{E}{1-\nu^2}$$

où $\sigma_{cr}$ est la contrainte critique de flambage
h est l'épaisseur de la membrane
a est la longueur de la membrane entre les ancrages
E est le module d'Young de la membrane
et $\nu$ est le coefficient de Poisson.

La flèche associée $W_0$ dépend de la contrainte dans la membrane et répond à l'équation ci-dessous :

$$W_0 = \pm 2{,}298 \times h.\sqrt{\frac{\sigma}{\sigma_{cr}} - 1} \quad \text{pour} \quad \sigma \geq \sigma_{cr}$$

La couche de flambage 6 qui va donner le capot 1 peut être assimilée à une membrane. Dans notre exemple des figures 12, selon le procédé de formation choisi pour la seconde sous-couche 6.2 en oxyde de silicium, à savoir oxydation thermique, dépôt PECVD, etc..., le niveau de contrainte interne dans la couche de flambage est plus ou moins élevé, et est compris entre environ 50 et 300 MPa. La température requise pour obtenir l'oxyde thermique a une valeur de l'ordre de 1000°C. Généralement, plus la température pendant la formation est élevée, plus la contrainte interne de compression de l'oxyde est élevée. Cependant, la température d'obtention de l'oxyde doit être compatible avec la température maximale d'utilisation de la première sous-couche 6.1 en parylène pour ne pas la dégrader. De récents développements sur le parylène peuvent laisser envisager des températures de dépôt de quelques centaines de degrés comme l'indique l'article "New High Temperature Polymer Thin Coating for Power Electronics" Rakesh Kumar et al. IEEE 2004, pages 1247-1249. Aussi, on peut choisir une seconde sous-couche d'oxyde 6.2 avec une contrainte interne de 100 MPa. Cette valeur se trouve dans le bas de la fourchette compte tenu de la limitation en température.

Cette contrainte interne doit donc être suffisante pour amorcer le flambage de la couche de flambage 6 dans l'hypothèse où les éléments de compression sont absents. On obtient :

$$100 MPa \geq 4,38 \times \frac{h^2}{a^2} \times \frac{E}{1-v^2}$$

On suppose que le microsystème a une forme de carré dont le côté a vaut 200 micromètres. Le module d'Young de l'oxyde de silicium est de 70 GPa, son coefficient de Poisson $v$ valant environ 0,17. Pour une telle configuration, on en déduit que l'épaisseur h de la seconde sous-couche 6.2 doit être inférieure à 3,56 micromètres. Une telle gamme d'épaisseurs est compatible avec les procédés de dépôt et de gravure de couches minces. Plus l'épaisseur h de la seconde sous-couche 6.2 est faible et plus la flèche $W_0$ est importante comme on peut le voir en se reportant au graphique de la figure 12E.

Par contre, plus l'épaisseur h de la seconde sous-couche 6.2 est faible et plus la tenue mécanique de la couche de flambage 6 est faible. Donc pour résister à des sollicitations mécaniques extérieures telles que des opérations d'assemblage ultérieures et pour permettre le flambage de la couche de flambage 6, un compromis en terme d'épaisseur est nécessaire. Ce compromis peut être déterminé de façon expérimentale et itérative.

Afin de mieux résister aux sollicitations mécaniques extérieures, il peut être intéressant d'augmenter l'épaisseur h de la seconde sous-couche 6.2 en oxyde et d'ajouter un ou plusieurs éléments de compression 8 pour permettre le flambage de la couche de flambage 6 et dépasser la contrainte critique. Ces éléments de compression 8 seront choisis pour avoir un coefficient de dilatation élevé, par exemple supérieur à $10^{-6}$ mm/K et un module d'Young élevé, par exemple quelques dizaines voire quelques centaines de GPa. Plus le module d'Young, le coefficient de dilatation et l'épaisseur des éléments de compression 8 sont élevés et plus les éléments de compression sont efficaces.

Il faut noter que certains paramètres ont été négligés dans les calculs précédents. Il s'agit d'une part de la différence de pression entre la pression atmosphérique environnant le microsystème 5 et la pression à l'intérieur la cavité 7 apparue après flambage de la couche de flambage 6 et d'autre part de l'adhérence de la couche de flambage 6 sur le substrat 2 qui n'est pas nulle, selon les configurations retenues. Il faut s'attendre à ce que la contrainte critique de flambage réelle soit supérieure à la contrainte critique de flambage théorique mentionnée ci-dessus.

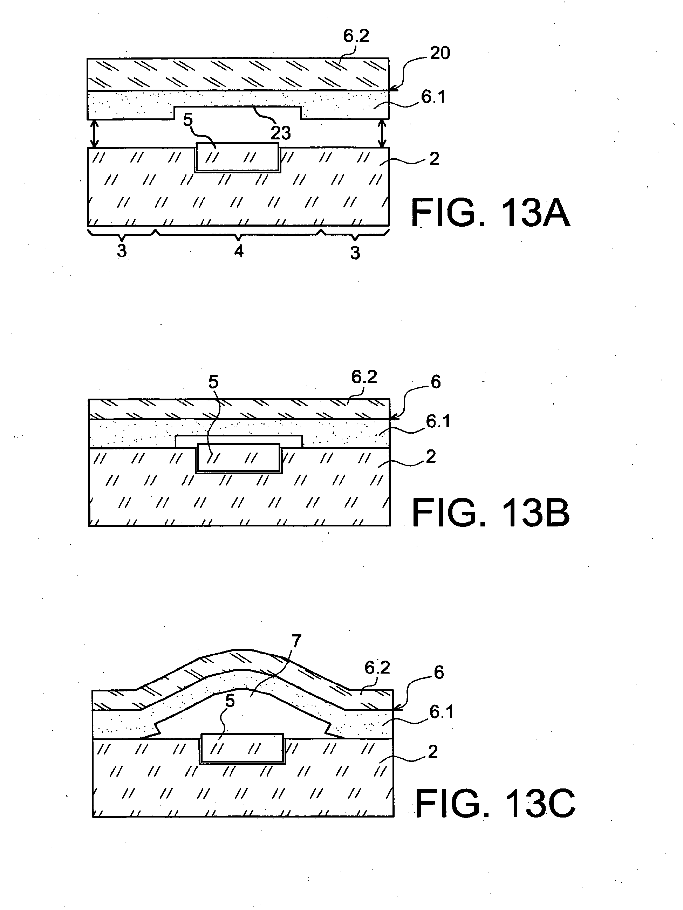

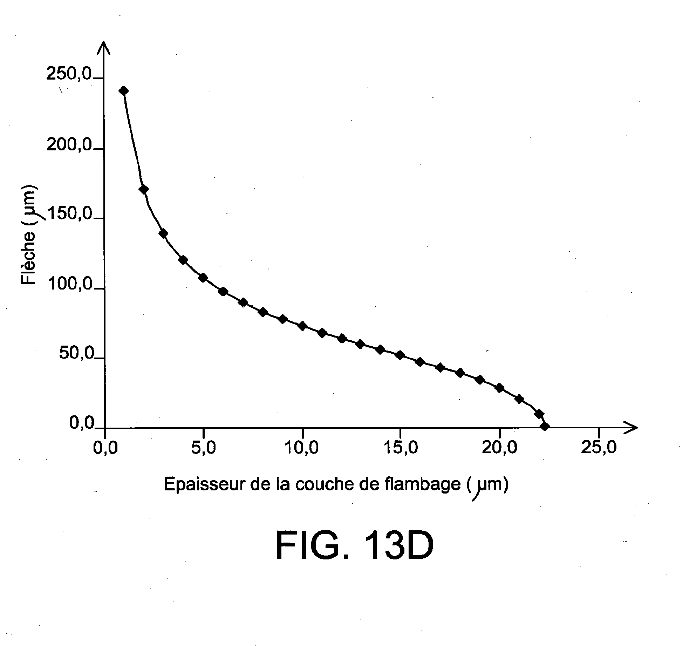

On va maintenant à s'intéresser à un autre exemple de réalisation d'au moins un capot 1 de protection d'un microsystème 5, par exemple de type capteur inertiel tel qu'un gyroscope ou un accéléromètre. On se réfère aux figures 13A à 13D. Ce type de microsystème fonctionne sous vide et est relativement coûteux, sa fabrication se faisant en petite quantité. La réalisation est différente et plus complexe que ce qui a été décrit précédemment. On suppose que le microsystème 5 est un carré de côté a valant par exemple 5mm x 5mm. Le microsystème 5 possède au moins un élément sensible mobile, c'est la partie visible sur les figures 13. La cavité 7 devant rester sous vide, il n'est pas souhaitable d'utiliser un matériau organique pour faire la couche de flambage, à cause d'un risque de dégazage.

On part d'un substrat 2 qui loge le microsystème 5. On suppose qu'il est en silicium. On définit en surface une zone centrale 4 englobant le microsystème 5 et au moins une zone d'ancrage 3 sur laquelle viendra s'ancrer la couche de flambage qui donnera le capot (figure 13A).

La couche de flambage 6 sera réalisée à partir d'un second substrat 20, représenté également sur la figure 12A, formé d'un empilement d'une sous-couche de silicium 6.2 et d'une sous-couche d'oxyde de silicium thermique 6.1. Ce second substrat 20 a une géométrie adaptée à celle de l'union entre la zone centrale 4 et la zone d'ancrage 3. On va assembler ce second substrat 20 au premier 2 par soudure directe silicium sur silicium, soudure eutectique, collage anodique par exemple.

La sous-couche 6.1 en oxyde thermique se retrouve du côté du premier substrat 2 (figure 13B). On suppose que la sous-couche d'oxyde thermique 6.1 a une épaisseur de l'ordre de 1 micromètre et une contrainte interne en compression de l'ordre de 300 MPa, ce qui est important.

Contrairement aux capots classiques qui sont en forme de cuvette pour donner son volume à la cavité, dans l'invention il n'est pas nécessaire que le second substrat 20 possède une dépression. C'est le flambage qui va donner à la cavité 7 son volume. Il peut être plat comme on l'avait représenté aux figures 11. Dans l'exemple des figures 13, on va toutefois prévoir une légère dépression 23 dans l'oxyde thermique qui se retrouvera après l'assemblage des deux substrats 2, 20 au dessus de la zone centrale 4 et donc du microsystème 5. Elle peut être obtenue par gravure sèche par exemple par gravure ionique réactive (RIE réactive ion etching) à base de $CHF_3O_2$. Le fait de prévoir une légère dépression 23 permet d'être sûr que le second substrat 20 n'adhérera pas au premier 2 au niveau de la zone centrale 4 lors de l'assemblage. S'il n'y a pas de dépression, on peut prévoir d'augmenter la rugosité de l'oxyde thermique à un niveau supérieur à environ 100 nm rms (rugosité moyenne de surface) au niveau de la partie du second substrat 20 qui viendra au niveau de la zone centrale 4, comme on l'a décrit plus haut.

Après l'étape d'assemblage, on prévoit un amincissement du second substrat 20, côté silicium, pour obtenir la couche de flambage 6 et lui donner une épaisseur appropriée à la flèche voulue lors du flambage (figure 13B). La sous-couche de silicium 6.2 pourrait être amincie et gravée jusqu'à disparaître totalement. La couche de flambage 6 serait alors monocouche et posséderait un maximum de contrainte.

Dans l'exemple décrit à la figure 13B, on conserve la sous-couche 6.1 en oxyde thermique et une sous-couche résiduelle 6.2 en silicium. L'article intitulé "Buckled membranes for microstructures" dont les références ont été données précédemment, divulgue la relation qui lie l'épaisseur $h_{SiO2}$ minimale de la sous-couche d'oxyde 6.1 nécessaire au flambage :

$$h_{SiO_2} = 2263 \frac{h^3}{a^2}$$

avec h épaisseur totale de la couche de flambage et a largeur de la couche de flambage entre les ancrages.

Au-delà de cette épaisseur, la flèche après flambage est définie par la relation suivante :

$$W_0 = 2,298 \times h \times \sqrt{4,419 \times 10^{-4} . \frac{h_{SIO_2}}{h} \frac{a^2}{h^2} - 1}$$

Dans notre exemple on suppose que : a = 5mm et $h_{SiO2}$ = 1$\mu$m. L'évolution de la flèche en fonction de l'épaisseur h est représentée dans le graphique de la figure 13D. L'épaisseur de la sous-couche résiduelle 6.2 en silicium peut ainsi être optimisée afin d'obtenir une flèche $W_0$ voulue pour la couche de flambage 6. Pour une flèche de 50 à 100$\mu$m, l'épaisseur de la sous-couche résiduelle 6.2 en silicium est de l'ordre de 5 à 15$\mu$m. Cette flèche est directement reliée au volume de la cavité 7 après flambage. En effet, la déformée de la couche de flambage 6 est donnée par la formule ci-dessous :

$$W(x, y) = \frac{W_0}{4}(1 + \cos\frac{2\pi}{a}x)(1 + \cos\frac{2\pi}{a}y)$$

En intégrant cette déformée sur toute la surface de la couche de flambage 6, on détermine ainsi le volume de la cavité 7.

La présente invention propose une solution alternative aux deux technologies traditionnelles d'encapsulation de microsystèmes : l'encapsulation couche mince et l'encapsulation par collage de capot silicium gravé dans un substrat. Sur la base de cette invention, une multitude de variantes peut être dégagée selon l'application et la filière du composant à protéger.

Un intérêt premier de cette invention est de proposer une solution séduisante tout particulièrement pour les microsystèmes destinés à la production de volume (MEMS radiofréquence, filtres à ondes acoustiques de volume). Actuellement, le procédé utilisé préférentiellement pour cette catégorie de microsystème est l'encapsulation couche mince. Les avantages du procédé de l'invention vis-à-vis de l'encapsulation couche mince sont les suivants. On n'a plus besoin d'utiliser de couche sacrificielle, on n'a plus besoin de reboucher le capot obtenu. Cette simplification est bénéfique à la fois pour les coûts de fabrication, les rendements visés étant supérieurs et pour le temps de cycle. Le capot obtenu dans l'invention est plus robuste à la tenue en flexion. En effet, la couche de flambage étant sous contrainte, sa tenue en flexion est améliorée. Le capot ainsi défini résiste donc mieux aux sollicitations extérieures. En fonction de la géométrie du composant et du design de la couche de flambage, il sera possible de trouver une configuration résistant à l'injection plastique. Les capots en couche mince conventionnels ne résistent pas à l'injection plastique. Une telle perspective est très encourageante car elle permettrait de traiter les microsystèmes ainsi encapsulés comme n'importe quel composant.

Dans cette perspective de résistance mécanique, l'utilisation de sol gel pour la couche de flambage 6 peut être intéressante dans la mesure où les épaisseurs déposées peuvent être supérieures tout en ayant un coefficient de dilatation thermique limité, similaire à celui de l'oxyde de silicium. Le sol gel est choisi en fonction de son adhérence, de sa porosité, de son coefficient de dilatation thermique, de son module d'Young et de sa position dans l'empilement de la couche de flambage. Ce n'est pas un produit standard.

Une autre solution potentielle consiste à utiliser un mode de mise en compression de la couche de flambage autre que thermique, par implantation ionique par exemple comme on l'a décrit aux figures 9. Ainsi lors de la montée en température liée à l'injection plastique (typiquement à 180°C), la contrainte de compression dans la couche de flambage est augmentée temporairement grâce au revêtement additionnel et grâce au substrat lui-même s'il a été choisi tel que la couche de flambage ait un coefficient de dilatation thermique supérieur à celui du substrat. La tenue en flexion de la couche de flambage est améliorée uniquement durant l'élévation en température. Les avantages de l'encapsulation couche mince sont quant à eux conservés comme l'utilisation des technologies de circuits intégrés, les basses températures et l'épaisseur du microsystème encapsulé limitée.

La présente invention présente des avantages par rapport à l'encapsulation avec un capot collé obtenu dans un substrat. L'augmentation de volume générée par le flambage de la couche de flambage lors de la création de la cavité contribue à diminuer la pression dans la cavité, puisque en première approximation le produit pression x volume est constant. Cette perspective est intéressante pour les microsystèmes fonctionnant sous vide, en complément de l'effet getter. Il est possible que l'une des sous-couches de la couche de flambage ait cette fonction de getter comme on l'a évoqué plus haut.

Le volume final de la cavité peut être ajusté par le niveau de contrainte dans la couche de flambage (température de dépôt, épaisseur des éléments de compression,...) ou par la tenue mécanique de la couche de flambage (épaisseur). La présente invention permet donc d'ajuster le niveau de vide au sein de la cavité et d'uniformiser ainsi le fonctionnement du composant, en limitant la dispersion provenant du niveau de vide. Cet ajustement peut être réalisé en cours de fabrication mais aussi en sortie de fabrication (après test électrique) ou encore en cours de vie du produit.

Dans ce dernier cas, comme élément de compression 8, il faudra alors prévoir un actionnement piloté par l'application (par exemple un actionnement piézoélectrique connu). On suppose qu'un tel actionnement piézoélectrique est schématisé sur la figure 12D.

Bien que plusieurs modes de réalisation de la présente invention aient été représentés et décrits de façon détaillée, on comprendra que différents changements et modifications puissent être apportés sans sortir du cadre de l'invention.

## Revendications

**1.** Procédé de réalisation d'un capot (1) de protection d'un composant (5) logé sur ou au sein d'un substrat (2) comprenant les étapes suivantes :

définition sur le substrat d'au moins une zone d'ancrage (3) du capot (1) au substrat (2), décalée d'une zone centrale (4) dans laquelle se trouve le composant (5),

formation d'une couche de flambage (6) monocouche ou a plusieurs sous-couches (6.1, 6.2, 6.3) empilées, sur le substrat (2), s'étendant sur la zone centrale (4) et au-delà, la couche de flambage (6) présentant une adhérence au substrat, dans la zone centrale (4), inférieure à celle présentée dans la zone d'ancrage (3),

flambage de la couche de flambage (6) de manière à ce qu'elle délimite une cavité (7) au niveau de la zone centrale (4) et soit ancrée au substrat (2) au niveau de la zone d'ancrage (3),

l'étape de définition pouvant être réalisée avant, pendant ou après l'étape de formation mais avant l'étape de flambage, l'étape de flambage pouvant être réalisée pendant ou après l'étape de formation.

**2.** Procédé selon la revendication 1, dans lequel la formation de la couche de flambage (6) se fait par dépôt de couche mince de type dépôt chimique en phase vapeur, dépôt physique en phase gazeuse, électrolyse, épitaxie, oxydation thermique, par dépôt sous vide, par laminage de film, par dépôt à la tournette, par pulvérisation, par moulage, par collage, moléculaire, par soudure eutectique, par collage anodique, par collage organique.

**3.** Procédé selon l'une des revendications 1 ou 2, dans lequel la formation de la couche de flambage (6) inclut une étape de structuration de la couche de flambage (6).

**4.** Procédé selon l'une des revendications précédentes, dans lequel la couche de flambage (6) ou les sous-couches (6.1, 6.2) de la couches de flambage sont réalisées en matériau organique choisi parmi des résines photosensibles comme le benzocyclobutène ou le polyéthylène téréphtalate, le parylène, le polydiméthylsiloxane, en matériau métallique choisi parmi le titane, le cuivre, l'aluminium ou leurs alliages, en matériau minéral choisi parmi le silicium, le silicium germanium, l'oxyde de silicium, le nitrure de silicium, le carbure de silicium, le carbone diamant, le nitrure de titane.

5. Procédé selon l'une des revendications 1 à 4, dans lequel le flambage est réalisé par maintien sous contrainte de la couche de flambage (6) ou d'au moins une sous-couche (6.1, 6.2) de la couche de flambage (6) suite à un traitement thermique.

6. Procédé selon la revendication 5, dans lequel la contrainte est induite par le substrat (2) qui possède un coefficient de dilatation thermique supérieur à celui de la couche de flambage (6) ou de la sous-couche (6.1, 6.2) de flambage.

7. Procédé selon l'une des revendications 5 ou 6, dans lequel la contrainte est induite par au moins une sous-couche (6.2) de la couche de flambage (6) qui possède un coefficient de dilatation thermique supérieur à celui d'une autre sous-couche (6.3) de la couche de flambage (6).

8. Procédé selon l'une des revendications 5 à 7, comprenant une étape de formation d'au moins un élément de compression (8) en périphérie de la couche de flambage (6), au niveau de la zone d'ancrage (3), cet élément de compression (8) ayant un coefficient de dilatation thermique supérieur à celui de la couche de flambage (6) ou d'au moins une des sous-couches (6.1, 6.2) de la couche de flambage et une rigidité supérieure à celle de la couche de flambage (6), la contrainte étant induite par l'élément de compression (8).

9. Procédé selon l'une des revendications 1 à 4, dans lequel le flambage est obtenu par une implantation ionique localisée de la couche de flambage (6) au niveau de la zone centrale (4) éventuellement couplée à une activation thermique simultanée et/ou ultérieure.

10. Procédé selon la revendication 9, comprenant une étape de dépôt d'un revêtement (23) à coefficient de dilatation thermique inférieur à celui de la couche de flambage (6) en périphérie de la couche de flambage (6), après le flambage, cette étape de dépôt étant suivie d'une étape de traitement thermique.

11. Procédé selon l'une des revendications 1 à 4, dans lequel le flambage est obtenu par dépôt par épitaxie sous contrainte d'au moins une sous-couche de la couche de flambage, cette étape étant éventuellement couplée à un traitement thermique.

12. Procédé selon l'une des revendications 1 à 4, dans lequel le flambage est obtenu par écrouissage sous plasma d'au moins une sous-couche de la couche de flambage, cette étape étant éventuellement couplée à un traitement thermique.

13. Procédé selon l'une des revendications 8 à 12, dans lequel l'élément de compression est soumis à une implantation ionique, un écrouissage sous plasma, un dépôt par épitaxie sous contrainte.

14. Procédé selon l'une des revendications 1 à 13, dans lequel la définition de la zone d'ancrage (3) se fait par réalisation d'un ou plusieurs points d'ancrage de la couche de flambage, en creux dans le substrat (2), au-delà de la zone centrale (4), avant la formation de la couche de flambage.

15. Procédé selon l'une des revendications précédentes, dans lequel la définition de la zone d'ancrage (3) se fait par traitement localisé du substrat (2) et/ou de la couche de flambage (6) visant à augmenter l'adhérence de la couche de flambage (6) sur le substrat (2) au-delà de la zone centrale (4).

16. Procédé selon la revendication 15, dans lequel le traitement est une application de plasma d'oxygène pour augmenter la rugosité de surface ou activer chimiquement la surface.

17. Procédé selon l'une des revendications précédentes, dans lequel la définition de la zone d'ancrage (3) se fait par dépôt localisé sur le substrat (2) et/ou la couche de flambage (6) d'un matériau visant à augmenter l'adhérence de la couche de flambage (6) sur le substrat (2) au-delà de la zone centrale (4).

18. Procédé selon la revendication 17, dans lequel le matériau est de la colle, de la soudure eutectique, un primaire d'adhérence.

**19.** Procédé selon l'une des revendications précédentes, dans lequel la définition de la zone d'ancrage (3) se fait par dépôt localisé sur le substrat (2) et/ou sur la couche de flambage (6) d'un matériau visant à dégrader l'adhérence de la couche de flambage (6) sur le substrat (2) au niveau de la zone centrale (4).

**20.** Procédé selon la revendication 19, dans lequel le matériau est un matériau peu ou pas adhérent choisi parmi le polytétrafluoroéthylène, les silicones, le parylène, le polydiméthysiloxane, les résines photosensibles.

**21.** Procédé selon la revendication 19, dans lequel le matériau est un matériau apte à être évaporé ou à être dégradé thermiquement, la couche de flambage ayant une première sous-couche poreuse (6.1) que l'on recouvre d'au moins une autre sous-couche (6.2) après l'évaporation ou la dégradation du matériau.

**22.** Procédé selon la revendication 21, dans lequel le matériau est aqueux ou une résine photosensible à base de polycarbonate.

**23.** Procédé selon l'une des revendications 21 ou 22, dans lequel une étape de traitement thermique ou de mise sous pression contrôlée est prévue après l'évaporation ou la dégradation pour permettre l'évacuation de résidus du matériau.

**24.** Procédé selon l'une des revendications précédentes, dans lequel la définition de la zone d'ancrage (3) se fait par traitement localisé du substrat (2) et/ou de la couche de flambage (6) visant à dégrader l'adhérence de la couche de flambage (6) sur le substrat (2) au niveau de la zone centrale (4).

**25.** Procédé selon la revendication 24, dans lequel le traitement est un traitement plasma visant à augmenter la rugosité en surface.

**26.** Procédé selon l'une des revendications précédentes, dans lequel la définition de la zone d'ancrage (3) se fait, par apport d'énergie localisé (22), au travers du substrat (2) et de la couche de flambage (6) superposés même si cette dernière est inachevée au-delà de la zone centrale (4) .

**27.** Composant (5) encapsulé comportant un substrat (2), un capot (1) solidaire du substrat (2) au niveau d'au moins une zone d'ancrage (3) délimitant une cavité (7) dans laquelle se trouve le composant (5), **caractérisé en ce que** le capot (1) est une couche de flambage (6) flambée.

**28.** Composant (5) selon la revendication 27, dans lequel la couche de flambage (6) est monocouche où comporte plusieurs sous-couches (6.1, 6.2) empilées.

**29.** Composant (5) selon l'une des revendications 27 ou 28, dans lequel la couche de flambage (6) est structurée.

**30.** Composant (5) selon l'une des revendications 28 ou 29, dans lequel la couche de flambage (6) ou les sous-couches (6.1, 6.2) de la couches de flambage (6) sont en matériau organique choisi parmi des résines photosensibles comme le benzocyclobutène ou le polyéthylène téréphtalate, le parylène, le polydiméthylsiloxane, en matériau métallique choisi parmi le titane, le cuivre, l'aluminium ou leurs alliages, en matériau minéral choisi parmi le silicium, l'oxyde de silicium, le nitrure de silicium, le carbure de silicium, le carbone diamant, le nitrure de titane.

**31.** Composant (5) selon l'une des revendications 28 à 30, dans lequel une ou plusieurs sous couches (6.1, 6.2) viennent en contact avec le substrat (2) dans la zone d'ancrage (3) .

**32.** Composant (5) selon l'une des revendications 28 à 31, dans lequel l'une des sous-couches (6.1) dont une face est exposée au moins en partie à l'intérieur de la cavité (7) a un rôle de getter.

**33.** Composant (5) selon l'une des revendications 28 à 32, dans lequel l'une des sous-couches (6.1) dont une face est exposée au moins en partie à l'intérieur de la cavité (7) est poreuse.

**34.** Composant (5) selon l'une des revendications 28 à 33, dans lequel l'une sous-couches (6.2) qui se trouve du côté de l'intérieur de la cavité (7) a un rôle de découplage mécanique avec le substrat (2) .

**35.** Composant (5) selon l'une des revendications 28 à 34, dans lequel l'une des sous-couches (6.2) a un rôle de tenue mécanique du capot (1).

36. Composant (5) selon l'une des revendications 28 à 35, dans lequel le substrat (2) a un coefficient de dilatation thermique supérieur à celui de la couche de flambage (6) ou à celui de l'une au moins de ses sous-couches (6.2).

37. Composant (5) selon l'une des revendications 28 à 36, dans lequel une des sous-couches (6.2) de la couche de flambage (6) a un coefficient de dilatation thermique supérieur à celui d'une autre sous-couche (6.3) de la couche de flambage (6) .

38. Composant (5) selon l'une des revendications 27 à 37, dans lequel au moins un élément de compression (8) surmonte la périphérie de la couche de flambage (6).

39. Composant (5) selon l'une des revendications 27 à 38, dans lequel le substrat (2) comporte un ou plusieurs points d'ancrage (3.2) en creux de la couche de flambage (6).

**Patentansprüche**

1. Verfahren zur Herstellung einer Schutzkappe (1) für ein Bauteil (5), das auf oder in einem Substrat (2) aufgenommen ist, umfassend die folgenden Schritte:

 Definieren, auf dem Substrat, wenigstens einer Verankerungszone (3) der Kappe (1) an dem Substrat (2), die von einer zentralen Zone (4) versetzt ist, in welcher sich das Bauteil (5) befindet,
 Bilden einer Krümmungsschicht (6) als Einzelschicht oder mit mehreren gestapelten Teilschichten (6.1, 6.2, 6.3) auf dem Substrat (2), die sich auf der zentralen Zone (4) und darüber hinaus erstreckt, wobei die Krümmungsschicht (6) eine Adhäsion an dem Substrat in der zentralen Zone (4) aufweist, die kleiner ist als jene die es in der Verankerungszone (3) aufweist,
 Krümmen der Krümmungsschicht (6) derart, dass sie im Bereich der zentralen Zone (4) einen Hohlraum (7) begrenzt und im Bereich der Verankerungszone (3) am Substrat (2) verankert ist,
 wobei der Schritt des Definierens vor, während oder nach dem Schritt des Bildens ausgeführt werden kann, jedoch vor dem Krümmungsschritt, wobei der Krümmungsschritt während oder nach dem Schritt des Bildens ausgeführt werden kann.

2. Verfahren nach Anspruch 1, bei dem das Bilden der Krümmungsschicht (6) durch Abscheiden einer dünnen Schicht erfolgt vom Typ chemische Dampfphasenabscheidung, physikalische Gasphasenabscheidung, Elektrolyse, Epitaxie, thermische Oxidation, durch Vakuumabscheidung, durch Filmlaminierung, durch Schleuderabscheidung, durch Pulverisierung, durch Giessen, durch Kleben, molekular, durch eutektisches Löten, durch anodisches Kleben, durch organisches Kleben.

3. Verfahren nach einem der Ansprüche 1 oder 2, bei dem das Bilden der Krümmungsschicht (6) einen Schritt der Strukturierung der Krümmungsschicht (6) umfasst.

4. Verfahren nach einem der vorhergehenden Ansprüche, bei dem die Krümmungsschicht (6) oder die Teilschichten (6.1, 6.2) der Krümmungsschicht aus organischem Material hergestellt ist/sind, ausgewählt aus den photoempfindlichen Harzen wie zum Beispiel Benzocyclobuten oder Polyethylenterephthalat, Parylene, Polydimethylsiloxan, aus metallischem Material ausgewählt aus Titan, Kupfer, Aluminium oder ihren Legierungen, aus mineralischem Material ausgewählt aus Silizium, Silizium-Germanium, Siliziumoxid, Siliziumnitrid, Siliciumcarbid, Diamantkohlenstoff, Titannitrid.

5. Verfahren nach einem der Ansprüche 1 bis 4, bei dem das Krümmen realisiert wird, indem man die Krümmungsschicht (6) oder wenigstens eine Teilschicht (6.1, 6.2) der Krümmungsschicht (6) im Anschluss an eine thermische Behandlung unter Spannung hält.

6. Verfahren nach Anspruch 5, bei dem die Spannung durch das Substrat (2) induziert wird, welches einen thermischen Ausdehnungskoeffizienten aufweist, der größer ist als jener der Krümmungsschicht (6) oder der Krümmungs-Teilschicht (6.1, 6.2).

7. Verfahren nach einem der Ansprüche 5 oder 6, bei dem die Spannung durch wenigstens eine Teilschicht (6.2) der Krümmungsschicht (6) induziert wird, die einen thermischen Ausdehnungskoeffizienten ausweist, der größer ist als jener einer anderen Teilschicht (6.3) der Krümmungsschicht (6).

**8.** Verfahren nach einem der Ansprüche 5 bis 7, umfassend einen Schritt des Bildens wenigstens eines Kompressionselements (8) am Umfang der Krümmungsschicht (6) im Bereich der Verankerungszone (3), wobei dieses Kompressionselement (8) einen thermischen Ausdehnungskoeffizient ausweist, der größer ist als jener der Krümmungsschicht (6) oder wenigstens einer der Teilschichten (6.1, 6.2) der Krümmungsschicht sowie eine Steifigkeit, die größer ist als jene der Krümmungsschicht (6), wobei die Spannung durch das Kompressionselement (8) induziert wird.

**9.** Verfahren nach einem der Ansprüche 1 bis 4, bei dem das Krümmen durch eine lokalisierte Ionenimplantation der Krümmungsschicht (6) im Bereich der zentralen Zone (4) erzielt wird, gegebenenfalls in Verbindung mit einer gleichzeitigen und/oder späteren thermischen Aktivierung.

**10.** Verfahren nach Anspruch 9, umfassend einen Schritt der Abscheidung einer Beschichtung (23) mit einem thermischen Ausdehnungskoeffizienten, der kleiner ist als jener der Krümmungsschicht (6), am Umfang der Krümmungsschicht (6) nach dem Krümmen, wobei auf diesen Abscheidungsschritt ein Schritt der thermischen Behandlung folgt.

**11.** Verfahren nach einem der Ansprüche 1 bis 4, bei dem das Krümmen durch epitaktisches Abscheiden wenigstens einer Teilschicht der Krümmungsschicht unter Spannung erzielt wird, wobei dieser Schritt gegebenenfalls in Verbindung mit einer thermischen Behandlung erfolgt.

**12.** Verfahren nach einem der Ansprüche 1 bis 4, bei dem das Krümmen durch Plasmakaltverformung wenigstens einer Teilschicht der Krümmungsschicht erzielt wird, wobei dieser Schritt gegebenenfalls in Verbindung mit einer thermischen Behandlung erfolgt.

**13.** Verfahren nach einem der Ansprüche 8 bis 12, bei dem das Kompressionselement einer Ionenimplantation, einer Plasmakaltverformung, einer epitaktischen Abscheidung unter Spannung ausgesetzt wird.

**14.** Verfahren nach einem der Ansprüche 1 bis 13, bei dem das Definieren der Verankerungszone (3) durch Realisieren eines oder mehrerer Verankerungspunkte der Krümmungsschicht vertieft in dem Substrat (2) jenseits der zentralen Zone (4) vor dem Bilden der Krümmungsschicht erfolgt.

**15.** Verfahren nach einem der vorhergehenden Ansprüche, bei dem das Definieren der Verankerungszone (3) durch lokale Behandlung des Substrats (2) und/oder der Krümmungsschicht (6) erfolgt, die darauf abzielt, die Adhäsion der Krümmungsschicht (6) auf dem Substrat (2) jenseits der zentralen Zone (4) zu erhöhen.

**16.** Verfahren nach Anspruch 15, bei dem die Behandlung eine Sauerstoffplasmaanwendung ist, um die Rauigkeit der Oberfläche zu erhöhen oder um die Oberfläche chemisch zu aktivieren.

**17.** Verfahren nach einem der vorhergehenden Ansprüche, bei dem das Definieren der Verankerungszone (3) durch lokale Abscheidung eines Materials auf dem Substrat (2) und/oder der Krümmungsschicht (6) erfolgt, das darauf abzielt, die Adhäsion der Krümmungsschicht (6) auf dem Substrat (2) jenseits der zentralen Zone (4) zu erhöhen.

**18.** Verfahren nach Anspruch 17, bei dem das Material Klebstoff, eutektisches Lot, ein Haftprimer ist.

**19.** Verfahren nach einem der vorhergehenden Ansprüche, bei dem das Definieren der Verankerungszone (3) durch lokales Abscheiden eines Materials auf dem Substrat (2) und/oder auf der Krümmungsschicht (6) erfolgt, das darauf abzielt, die Adhäsion der Krümmungsschicht (6) auf dem Substrat (2) im Bereich der zentralen Zone (4) zu verschlechtern.

**20.** Verfahren nach Anspruch 19, bei dem das Material ein wenig oder nicht haftendes Material ist, ausgewählt aus Polytetrafluorethylen, den Silikonen, Parylen, Polydimethylsiloxan, den photoempfindlichen Harzen.

**21.** Verfahren nach Anspruch 19, bei dem das Material ein Material ist, das verdampft oder thermisch abgebaut werden kann, wobei die Krümmungsschicht eine erste poröse Teilschicht (6.1) hat, die man mit wenigstens einer weiteren Teilschicht (6.2) nach der Verdampfung oder dem Abbau des Materials bedeckt.

**22.** Verfahren nach Anspruch 21, bei dem das Material wässrig oder ein photoempfindliches Harz auf Polycarbonatbasis ist.

**23.** Verfahren nach einem der Ansprüche 21 oder 22, bei dem nach der Verdampfung oder dem Abbau ein Schritt der thermischen Behandlung oder des gesteuerten Unter-Druck-Setzens vorgesehen ist, um die Beseitigung der Reste des Materials zu ermöglichen.

**24.** Verfahren nach einem der vorhergehenden Ansprüche, bei dem das Definieren der Verankerungszone (3) durch lokale Behandlung des Substrats (2) und/oder der Krümmungsschicht (6) erfolgt, die darauf abzielt, die Adhäsion der Krümmungsschicht (6) auf dem Substrat (2) im Bereich der zentralen Zone (4) zu verschlechtern.

**25.** Verfahren nach Anspruch 24, bei dem die Behandlung eine Plasmabehandlung ist, die darauf abzielt, die Rauigkeit an der Oberfläche zu erhöhen.

**26.** Verfahren nach einem der vorhergehenden Ansprüche, bei dem das Definieren der Verankerungszone (3) durch lokale Energiezufuhr (22) durch das Substrat (2) und die überlagerte Krümmungsschicht (6) hindurch erfolgt, selbst wenn Letztgenannte jenseits der zentralen Zone (4) unvollendet ist.

**27.** Gekapseltes Bauteil (5), umfassend ein Substrat (2), eine Kappe (1), die mit dem Substrat (2) im Bereich wenigstens einer Verankerungszone (3) verbunden ist, die einen Hohlraum (7) begrenzt, in dem sich das Bauteil (5) befindet, **dadurch gekennzeichnet, dass** die Kappe (1) eine gekrümmte Krümmungsschicht (6) ist.

**28.** Bauteil (5) nach Anspruch 27, bei dem die Krümmungsschicht (6) eine Einzelschicht ist oder mehrere gestapelte Teilschichten (6.1, 6.2) umfasst.

**29.** Bauteil (5) nach einem der Ansprüche 27 oder 28, bei dem die Krümmungsschicht (6) strukturiert ist.

**30.** Bauteil (5) nach einem der Ansprüche 28 oder 29, bei dem die Krümmungsschicht (6) oder die Teilschichten (6.1, 6.2) der Krümmungsschicht (6) aus organischem Material sind, ausgewählt aus den photoempfindlichen Harzen wie Benzocyclobuten oder Polyethylenterephthalat, Parylen, Polydimethylsiloxan, aus metallischem Material ausgewählt aus Titan, Kupfer, Aluminium oder ihren Legierungen, aus mineralischem Material ausgewählt aus Silizium, Siliziumoxid, Siliziumnitrid, Siliziumcarbid, Diamantkohlenstoff, Titannitrid.

**31.** Bauteil (5) nach einem der Ansprüche 28 bis 30, bei dem eine oder mehrere Teilschichten (6.1, 6.2) in der Verankerungszone (3) in Kontakt mit dem Substrat (2) gelangen.

**32.** Bauteil (5) nach einem der Ansprüche 28 bis 31, bei dem eine der Teilschichten (6.1), deren eine Seite wenigstens teilweise im Inneren des Hohlraums (7) freiliegt, eine Getter-Rolle hat.

**33.** Bauteil (5) nach einem der Ansprüche 28 bis 32, bei dem eine der Teilschichten (6.1) deren eine Seite wenigstens teilweise im Inneren des Hohlraums (7) freiliegt, porös ist.

**34.** Bauteil (5) nach einem der Ansprüche 28 bis 33, bei dem eine der Teilschichten (6.2), die sich auf der Seite des Inneren des Hohlraums (7) befindet, die Rolle eines mechanischen Entkopplers mit dem Substrat (2) hat.

**35.** Bauteil (5) nach einem der Ansprüche 28 bis 34, bei dem eine der Teilschichten (6.2) die Rolle eines mechanischen Halters für die Kappe (1) hat.

**36.** Bauteil (5) nach einem der Ansprüche 28 bis 35, bei dem das Substrat (2) einen thermischen Ausdehnungskoeffizienten hat, der größer ist als jener der Krümmungsschicht (6) oder als jener wenigstens einer ihrer Teilschichten (6.2).

**37.** Bauteil (5) nach einem der Ansprüche 28 bis 36, bei dem eine der Teilschichten (6.2) der Krümmungsschicht (6) einen thermischen Ausdehnungskoeffizienten hat, der größer ist als jener einer anderen Teilschicht (6.3) der Krümmungsschicht (6).

**38.** Bauteil (5) nach einem der Ansprüche 27 bis 37, bei dem wenigstens ein Kompressionselement (8) den Umfang der Krümmungsschicht (6) überragt.

**39.** Bauteil (5) nach einem der Ansprüche 27 bis 38, bei dem das Substrat (2) einen oder mehrere Verankerungspunkte (3.2) tief in der Krümmungsschicht (6) umfasst.

**Claims**

1. Method for preparing a cover (1) for protecting a component (5) housed on or in a substrate (2) comprising the following steps:

   definition on the substrate of at least one zone (3) for anchoring the cover (1) of the substrate (2), offset from a central zone (4) in which the component (5) is located,
   formation of a buckling layer (6) having a monolayer or a plurality of stacked sub-layers (6.1, 6.2, 6.3), on the substrate (2), extending on the central zone (4) and beyond, the buckling layer (6) having an adhesion to the substrate, in the central zone (4), lower than that presented in the anchoring zone (3),
   buckling of the buckling layer (6) so that it bounds a cavity (7) at the central zone (4) and is anchored to the substrate (2) at the anchoring zone (3),
   the definition step can be carried out before, during or after the formation step but before the buckling step, and the buckling step can be carried out during or after the formation step.

2. Method according to claim 1, wherein the buckling layer (6) is formed by the deposition of a thin film such as chemical vapour deposition, physical vapour deposition, electrolysis, epitaxy, thermal oxidation, vacuum deposition, film lamination, spin deposition, spraying, moulding, molecular bonding, eutectic welding, anodic bonding, organic bonding.

3. Method according to either of claims 1 and 2, wherein the formation of the buckling layer (6) includes a step of structuring of the buckling layer (6).

4. Method according to one of the preceding claims, wherein the buckling layer (6) or the sub-layers (6.1, 6.2) of the buckling layer are made from an organic material selected from photosensitive resins such as benzocyclobutene or polyethylene terephthalate, parylene, polydimethylsiloxane, a metallic material selected from titanium, carbon, aluminium or alloys thereof, an inorganic material selected from silicon, silicon germanium, silicon dioxide, silicon nitride, silicon carbide, diamond carbon, titanium nitride.

5. Method according to one of claims 1 to 4, wherein the buckling is carried out by maintaining the buckling layer (6) or at least one sub-layer (6.1, 6.2) of the buckling layer (6) under stress following a heat treatment.

6. Method according to claim 5, wherein the stress is induced by the substrate (2) which has a thermal expansion coefficient higher than that of the buckling layer (6) or of the buckling sub-layer (6.1, 6.2).

7. Method according to either of claims 5 and 6, wherein the stress is induced by at least one sub-layer (6.2) of the buckling layer (6) which has a thermal expansion coefficient higher than that of another sub-layer (6.3) of the buckling layer (6).

8. Method according to one of claims 5 to 7, comprising a step of formation of at least one compression element (8) at the periphery of the buckling layer (6), at the anchoring zone (3), this compression element (8) having a thermal expansion coefficient higher than that of the buckling layer (6) or of at least one of the sub-layers (6.1, 6.2) of the buckling layer and a stiffness higher than that of the buckling layer (6), the stress being induced by the compression element (8).

9. Method according to one of claims 1 to 4, wherein the buckling is obtained by a localized ion implantation of the buckling layer (6) at the central zone (4) optionally coupled with a simultaneous and/or subsequent thermal activation.

10. Method according to claim 9, comprising a step of depositing a coating (23) having a thermal expansion coefficient lower than that of the buckling layer (6) at the periphery of the buckling layer (6), after the buckling, this deposition step being followed by a heat treatment step.

11. Method according to one of claims 1 to 4, wherein the buckling is obtained by epitaxial stress deposition of at least one sub-layer of the buckling layer, this step optionally being coupled with a heat treatment.

12. Method according to one of claims 1 to 4, wherein the buckling is obtained by plasma hardening of at least one sub-layer of the buckling layer, this step being optionally coupled with a heat treatment.

13. Method according to one of claims 8 to 12, wherein the compression element is subject to an ion implantation, a plasma hardening, an epitaxial stress deposition.

14. Method according to one of claims 1 to 13, wherein the anchoring zone (3) is defined by the preparation of one or more anchoring points of the buckling layer, hollowed in the substrate (2), beyond the central zone (4), before the formation of the buckling layer.

15. Method according to one of the preceding claims, wherein the anchoring zone (3) is defined by localized treatment of the substrate (2) and/or of the buckling layer (6) in order to increase the adhesion of the buckling layer (6) to the substrate (2) beyond the central zone (4).

16. Method according to claim 15, wherein the treatment is an oxygen plasma application to increase the surface roughness or to chemically activate the surface.

17. Method according to one of the preceding claims, wherein the anchoring zone (3) is defined by localized deposition on the substrate (2) and/or the buckling layer (6) of a material suitable for increasing the adhesion of the buckling layer (6) to the substrate (2) beyond the central zone (4).

18. Method according to claim 17, wherein the material is an adhesive, a eutectic weld, a bonding primer.

19. Method according to one of the preceding claims, wherein the anchoring zone (3) is defined by localized deposition on the substrate (2) and/or the buckling layer (6) of a material suitable for decreasing the adhesion of the buckling layer (6) to the substrate (2) beyond the central zone (4).

20. Method according to claim 19, wherein the material is a slightly adhesive or non-adhesive material selected from polytetrafluoroethylene, silicones, parylene, polydimethysiloxane, photosensitive resins.

21. Method according to claim 19, wherein the material is a material suitable for being evaporated or for being thermally degraded, the buckling layer having a first porous sub-layer (6.1) which is covered with at least one of the sub-layer (6.2) after the evaporation or the degradation of the material.

22. Method according to claim 21, wherein the material is aqueous or a photosensitive resin based on polycarbonate.

23. Method according to either of claims 21 and 22, wherein a heat treatment step or a controlled pressurization step is provided after the evaporation or the degradation to permit the removal of waste material.

24. Method according to one of the preceding claims, wherein the anchoring zone (3) is defined by localized treatment of the substrate (2) and/or the buckling layer (6) suitable for decreasing the adhesion of the buckling layer (6) to the substrate (2) at the central zone (4).

25. Method according to claim 24, wherein the treatment is a plasma treatment for increasing the surface roughness.

26. Method according to one of the preceding claims, wherein the anchoring zone (3) is defined by localized energy input (22), across the superimposed substrate (2) and buckling layer (6) even if the said definition is incomplete beyond the central zone (4).

27. Encapsulated component (5) comprising a substrate (2), a cover (1) joined to the substrate (2) at the level of at least one anchoring zone (3) bounding a cavity (7) in which the component (5) is located, **characterized in that** the cover (1) is a buckled buckling layer (6).

28. Component (5) according to claim 27, wherein the buckling layer (6) is a monolayer or comprises a plurality of stacked sub-layers (6.1, 6.2).

29. Component (5) according to either of claims 27 and 28, wherein the buckling layer (6) is structured.

30. Component (5) according to either of claims 28 and 29, wherein the buckling layer (6) or the sub-layers (6.1, 6.2) of the buckling layer (6) are made from an organic material selected from photosensitive resins such as benzocyclobutene or polyethylene terephthalate, parylene, polydimethylsiloxane, a metallic material selected from titanium, carbon, aluminium or alloys thereof, an inorganic material selected from silicon, silicon germanium, silicon dioxide, silicon nitride, silicon carbide, diamond carbon, titanium nitride.

31. Component (5) according to one of claims 28 to 30, wherein one or more sub-layers (6.1, 6.2) are in contact with the substrate (2) in the anchoring zone (3) .

32. Component (5) according to one of claims 28 to 31, wherein one of the sub-layers (6.1) of which one side is exposed at least partly to the interior of the cavity (7) has a getter role.

33. Component (5) according to one of claims 28 to 32, wherein one of the sub-layers (6.1) of which one side is exposed at least partly to the interior of the cavity (7) is porous.

34. Component (5) according to one of claims 28 to 33, wherein one of the sub-layers (6.2) which is located on the side of the interior of the cavity (7) has a role of mechanical uncoupling with the substrate (2) .

35. Component (5) according to one of claims 28 to 34, wherein one of the sub-layers (6.2) has a role of mechanically strengthening the cover (1).

36. Component (5) according to one of claims 28 to 35, wherein the substrate (2) has a thermal expansion coefficient higher than that of the buckling layer (6) or than that of at least one of its sub-layers (6.2).

37. Component (5) according to one of claims 28 to 36, wherein one of the sub-layers (6.2) of the buckling layer (6) has a thermal expansion coefficient higher than that of another sub-layer (6.3) of the buckling layer (6).

38. Component (5) according to one of claims 27 to 37, wherein at least one compression element (8) surmounts the periphery of the buckling layer (6).

39. Component (5) according to one of claims 27 to 38, wherein the substrate (2) comprises one or more anchoring points (3.2) hollowed in the buckling layer (6) .

FIG. 1A

FIG. 1B

FIG. 1C

FIG. 1D

FIG. 1E

FIG. 2A

FIG. 2B

FIG. 2C

FIG. 2D

FIG. 3A

FIG. 3B

FIG. 3C

FIG. 3D

FIG. 4A

FIG. 4B

FIG. 5A

FIG. 5B

FIG. 5C

FIG. 5D

FIG. 6A

FIG. 6B

FIG. 6C

FIG. 6D

FIG. 6E

FIG. 6F

FIG. 7A

FIG. 7B

FIG. 8A

FIG. 8B

FIG. 8C

FIG. 8D

FIG. 8E

FIG. 8F

FIG. 9A

FIG. 9B

FIG. 9C

FIG. 10A

FIG. 10B

**FIG. 10C**

**FIG. 10D**

**FIG. 10E**

**FIG. 10F**

FIG. 11A

FIG. 11B

FIG. 11C

FIG. 11D

FIG. 12A

FIG. 12B

FIG. 12C

FIG. 12D

Epaisseur d'oxyde ( µm)

FIG. 12E

FIG. 13A

FIG. 13B

FIG. 13C

39

FIG. 13D

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2864341 A1

**Littérature non-brevet citée dans la description**

- **V. N. GURARIE et al.** Crack-arresting compression layers produced by ion implantation. *Nuclear Instruments And Methods In Physics Research,* 2006, vol. B242, 421-423
- **LIGER MATTHIEU et al.** Robust parylene-to-silicon mechanical anchoring. *16th IEEE International MEMS Conference (MEMS'03), Kyoto, Japan,* 19 Janvier 2003, 602-605
- **SHOJI TAKEUCHI et al.** Parylene flexible neural probe with micro fluidic channel. *IEEE,* 2004, 208-211
- **DAN S. POPESCU et al.** Buckled membranes for microstructures. *0-7803-1833-1/94 IEEE,* 1994, 188-192
- **DAN S. POPESCU et al.** Silicon active microvalves using buckled membranes for actuation. *Transducers '95, the 8th International Conference on solid-state sensors and actuators, and Eurosensors IX, Stockholm, Sweden,* 25 Juin 1995, 305-308
- **RAKESH KUMAR et al.** New High Temperature Polymer Thin Coating for Power Electronics. *IEEE,* 2004, 1247-1249